(19) Europäisches Patentamt
European Patent Office
Office européen des brevets

(11) **EP 4 760 318 A1**

(12) **EUROPEAN PATENT APPLICATION**
published in accordance with Art. 153(4) EPC

(43) Date of publication:
**17.06.2026 Bulletin 2026/25**

(21) Application number: **25776853.1**

(22) Date of filing: **25.02.2025**

(51) International Patent Classification (IPC):
***G01R 31/396*** *(2019.01)* ***G01R 31/382*** *(2019.01)*
***G01R 31/392*** *(2019.01)* ***B60L 58/16*** *(2019.01)*

(52) Cooperative Patent Classification (CPC):
**B60L 58/16; G01R 31/382; G01R 31/392; G01R 31/396**

(86) International application number:
**PCT/KR2025/002620**

(87) International publication number:
**WO 2025/206594 (02.10.2025 Gazette 2025/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.03.2024 KR 20240040392**

(71) Applicant: **LG Energy Solution, Ltd.**
**Seoul 07335 (KR)**

(72) Inventors:
- **PARK, Hyun-Joo**
  **Daejeon 34122 (KR)**
- **CHOI, Soon-Ju**
  **Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **METHOD AND APPARATUS FOR DIAGNOSING BATTERY**

(57) A method for diagnosing a battery according to one aspect of the present disclosure includes a voltage determining step of determining an OCV (Open Circuit Voltage) of a battery; a capacity selecting step of selecting a positive electrode capacity corresponding to the OCV from a positive electrode profile representing a corresponding relationship between the positive electrode capacity and a positive electrode voltage of the battery, and a negative electrode capacity corresponding to the OCV from a negative electrode profile representing a corresponding relationship between the negative electrode capacity and a negative electrode voltage of the battery; a depth calculating step of calculating a positive electrode depth, which is a ratio of the selected positive electrode capacity to a positive electrode entire capacity of the battery, and a negative electrode depth, which is a ratio of the selected negative electrode capacity to a negative electrode entire capacity of the battery; and a diagnosing step of diagnosing a state of the battery based on at least one of the positive electrode depth and the negative electrode depth.

FIG. 1

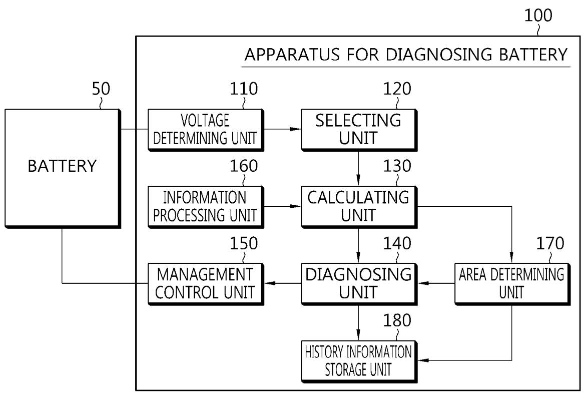


EP 4 760 318 A1

## Description

### TECHNICAL FIELD

This application is based on and claims priority from Korean Patent Application No. 10-2024-0040392, filed on March 25, 2024, with the Korean Intellectual Property Office, the disclosure of which is incorporated herein in its entirety by reference.

The present disclosure relates to a technology for diagnosing the state of a battery, and more specifically, to a method and apparatus for diagnosing a battery for effectively diagnosing the degradation state of a battery that undergoes repeated charging and discharging.

### BACKGROUND ART

As the demand for portable electronic products such as laptops, video cameras, and mobile phones that use electricity as a power source increases rapidly, and as mobile robots, electric bicycles, electric carts, electric vehicles, and ESSs (Energy Storage Systems) become more widely commercialized, research on high-performance batteries capable of repeated charging and discharging is actively being conducted.

Currently available batteries include lithium batteries that use lithium ions, such as lithium-ion batteries or lithium-ion polymer batteries, and nickel cadmium batteries, nickel hydrogen batteries, and nickel zinc batteries. Among these, lithium batteries have the advantages of having a relatively long lifespan, a very low self-discharge rate, and high energy density because they have almost no memory effect compared to batteries that use nickel, and thus their application range is gradually expanding.

The positive electrode and negative electrode of these batteries are gradually degraded or aged as the charge and discharge cycles are repeated, and the batteries no longer maintain the performance at the BOL (Beginning Of Life) time. Therefore, in order to accurately predict the usable time, remaining life, and replacement time of the battery, an accurate diagnosis of the battery state is required.

However, since the existing technology simply diagnoses the battery through the SOH (State of Health) of the entire battery, there is a problem in that the state of the battery cannot be diagnosed for each electrode.

### DISCLOSURE

### Technical Problem

The present disclosure is designed to solve the problems of the related art, and therefore the present disclosure is directed to providing a method and apparatus for diagnosing a battery, which may simply and accurately diagnose the state of the battery by distinguishing the state by electrode by quantifying the depth of each electrode and the usage area of each electrode using a profile that represents the OCV and electrical characteristics of the battery.

The technical problems that the present disclosure seeks to solve are not limited to the problems described above, and other problems not mentioned above will be clearly understood by those skilled in the art from the description of the invention below.

### Technical Solution

A method for diagnosing a battery according to one aspect of the present disclosure comprises a voltage determining step of determining an OCV (Open Circuit Voltage) of a battery; a capacity selecting step of selecting a positive electrode capacity corresponding to the OCV from a positive electrode profile representing a corresponding relationship between the positive electrode capacity and a positive electrode voltage of the battery, and a negative electrode capacity corresponding to the OCV from a negative electrode profile representing a corresponding relationship between the negative electrode capacity and a negative electrode voltage of the battery; a depth calculating step of calculating a positive electrode depth, which is a ratio of the selected positive electrode capacity to a positive electrode entire capacity of the battery, and a negative electrode depth, which is a ratio of the selected negative electrode capacity to a negative electrode entire capacity of the battery; and a diagnosing step of diagnosing a state of the battery based on at least one of the positive electrode depth and the negative electrode depth.

In an embodiment, the voltage determining step may include a step of determining a first OCV, which is an OCV at a charge end of the battery, and a second OCV, which is an OCV at a discharge end of the battery, the capacity selecting step may include a step of selecting a positive electrode charging capacity, which is a positive electrode capacity corresponding to the first OCV, and a positive electrode discharging capacity, which is a positive electrode capacity corresponding to the second OCV, in the positive electrode profile, and the depth calculating step may include a step of calculating at least one of a positive electrode charging depth, which is a ratio of the positive electrode charging capacity to the positive electrode entire capacity, and a positive electrode discharging depth, which is a ratio of the positive electrode discharging capacity to the positive electrode entire capacity, as the positive electrode depth.

In this case, the diagnosing step may include a step of diagnosing whether a positive electrode of the battery is degraded based on at least one of the positive electrode charging depth and the positive electrode discharging depth.

In an embodiment, the voltage determining step may include a step of determining a first OCV, which is an OCV at a charge end of the battery, and a second OCV, which is an OCV at a discharge end of the battery, the capacity selecting step may include a step of selecting a negative electrode charging capacity, which is a negative electrode capacity corresponding to the first OCV, and a negative electrode discharging capacity, which is a negative electrode capacity corresponding to the second OCV, in the negative electrode profile, and the depth calculating step may include a step of calculating at least one of a negative electrode charging depth, which is a ratio of the negative electrode charging capacity to the negative electrode entire capacity, and a negative electrode discharging depth, which is a ratio of the negative electrode discharging capacity to the negative electrode entire capacity, as the negative electrode depth.

In this case, the diagnosing step may include a step of diagnosing whether a negative electrode of the battery is degraded based on at least one of the negative electrode charging depth and the negative electrode discharging depth.

In an embodiment, the capacity selecting step may include obtaining a battery profile representing a corresponding relationship between a voltage and a capacity of the battery; adjusting a predetermined reference positive electrode profile and a reference negative electrode profile to correspond to the battery profile to determine the positive electrode profile and the negative electrode profile; and selecting a positive electrode capacity corresponding to the OCV in the positive electrode profile, and selecting a negative electrode capacity corresponding to the OCV in the negative electrode profile.

In an embodiment, the diagnosing step may include diagnosing whether a positive electrode of the battery is degraded based on the positive electrode depth; and diagnosing whether a negative electrode of the battery is degraded based on the negative electrode depth.

In an embodiment, the diagnosing step may include a step of diagnosing the state of the battery as a degradation state when the positive electrode depth is less than or equal to a predetermined first reference value, when the negative electrode depth is less than or equal to a predetermined second reference value, or when the positive electrode depth is less than or equal to the first reference value and the negative electrode depth is less than or equal to the second reference value.

In an embodiment, the method for diagnosing a battery may further comprise controlling a usage condition of the battery when the state of the battery is diagnosed as a degradation state.

An apparatus for diagnosing a battery according to another aspect of the present disclosure comprises a voltage determining unit configured to determine an OCV of a battery; a selecting unit configured to select a positive electrode capacity corresponding to the OCV from a positive electrode profile representing a corresponding relationship between the positive electrode capacity and a positive electrode voltage of the battery, and a negative electrode capacity corresponding to the OCV from a negative electrode profile representing a corresponding relationship between the negative electrode capacity and a negative electrode voltage of the battery; a calculating unit configured to calculate a positive electrode depth, which is a ratio of the selected positive electrode capacity to a positive electrode entire capacity of the battery, and a negative electrode depth, which is a ratio of the selected negative electrode capacity to a negative electrode entire capacity of the battery; and a diagnosing unit configured to diagnose a state of the battery based on at least one of the positive electrode depth and the negative electrode depth.

In an embodiment, the voltage determining unit may be configured to determine a first OCV, which is an OCV at a charge end of the battery, and a second OCV, which is an OCV at a discharge end of the battery, the selecting unit may be configured to select a positive electrode charging capacity, which is a positive electrode capacity corresponding to the first OCV, and a positive electrode discharging capacity, which is a positive electrode capacity corresponding to the second OCV, in the positive electrode profile, and the calculating unit may be configured to calculate at least one of a positive electrode charging depth, which is a ratio of the positive electrode charging capacity to the positive electrode entire capacity, and a positive electrode discharging depth, which is a ratio of the positive electrode discharging capacity to the positive electrode entire capacity, as the positive electrode depth.

In an embodiment, the voltage determining unit may be configured to determine a first OCV, which is an OCV at a charge end of the battery, and a second OCV, which is an OCV at a discharge end of the battery, the selecting unit may be configured to select a negative electrode charging capacity, which is a negative electrode capacity corresponding to the first OCV, and a negative electrode discharging capacity, which is a negative electrode capacity corresponding to the second OCV, in the negative electrode profile, and the calculating unit may be configured to calculate at least one of a negative electrode charging depth, which is a ratio of the negative electrode charging capacity to the negative electrode entire capacity, and a negative electrode discharging depth, which is a ratio of the negative electrode discharging capacity to the negative electrode entire capacity, as the negative electrode depth.

In an embodiment, the diagnosing unit may be configured to diagnose whether a positive electrode of the battery is degraded based on the positive electrode depth, and diagnose whether a negative electrode of the battery is degraded based on the negative electrode depth.

A battery pack according to still another aspect of the present disclosure may comprise the apparatus for diagnosing a battery as described above.

A vehicle according to still another aspect of the present disclosure may comprise the apparatus for diagnosing a battery as described above.

## Advantageous Effects

According to the present disclosure, the charging depth and discharging depth of the battery according to the progress of the charge and discharge cycles, as well as the unused area of the battery, may be quantified by dividing it by electrode, thereby accurately diagnosing the degradation state of the battery by electrode.

In addition, according to the present disclosure, by using the OCV at the charge end (EoC OCV) and the OCV at the discharge end (EoD OCV), which change according to the degradation of the battery, as diagnostic parameters, the change in the charge characteristics and the change in the discharge characteristics of each electrode of the battery may be expressed in quantifiable numbers.

In addition, according to the present disclosure, by performing software processing on the negative electrode profile and positive electrode profile of the battery, the state of the battery may be quickly and accurately diagnosed by providing quantitative figures for the positive electrode depth and negative electrode depth corresponding to the OCV of the battery measured in the current cycle.

In addition, according to the present disclosure, by controlling or adjusting the usage condition or usage environment of the battery based on data regarding the positive electrode charging depth, the positive electrode discharging depth, the negative electrode charging depth, and the negative electrode discharging depth, it is possible to delay the degradation of the battery and improve the safety of the battery.

Furthermore, a person having ordinary skill in the art to which the present disclosure belongs will be able to clearly understand from the following description that various embodiments according to the present disclosure can solve various technical problems not mentioned above.

## DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a block diagram showing an apparatus for diagnosing a battery according to an embodiment of the present disclosure.

FIG. 2 is a block diagram showing a selecting unit of the apparatus for diagnosing a battery shown in FIG. 1.

FIG. 3 is a flow chart showing a method for diagnosing a battery according to an embodiment of the present disclosure.

FIG. 4 is a flow chart showing a process for determining an unused area of a battery in a method for diagnosing a battery according to an embodiment of the present disclosure.

FIG. 5 is a flow chart showing a process for calculating a positive electrode capacity and a negative electrode capacity in the method for diagnosing a battery according to an embodiment of the present disclosure.

FIG. 6 is a graph showing a change in the charge end voltage of a battery according to an increase in the number of cycles.

FIG. 7 is a graph showing a change in the discharge end voltage of a battery according to an increase in the number of cycles.

FIG. 8 is a drawing showing an example of a positive electrode profile of a battery.

FIG. 9 is a drawing showing an example of a negative electrode profile of a battery.

FIG. 10 is a graph showing changes in a positive electrode charging depth and a positive electrode discharging depth of a battery according to an increase in the cumulative driving distance of an electric vehicle using the battery.

FIG. 11 is a graph showing changes in a negative electrode charging depth and a negative electrode discharging depth of a battery according to an increase in the cumulative driving distance of an electric vehicle using the battery.

FIG. 12 is a drawing showing an example of a battery profile.

FIG. 13 is a drawing showing an example of a reference positive electrode profile and a reference negative electrode profile.

FIG. 14 is a drawing showing an example of a positive electrode profile and a negative electrode profile of a battery.

BEST MODE

Hereinafter, in order to clarify the solution corresponding to the technical challenge of the present disclosure, embodiments according to the present disclosure will be described in detail with reference to the attached drawings. However, when explaining the present disclosure, if a description of a related publicly known technology obscures the gist of the present disclosure, the description thereof may be omitted.

In addition, the terms used in this specification are terms defined in consideration of the functions in the present disclosure, and these may vary depending on the intention or custom of the designer, manufacturer, etc. Therefore, the definitions of the terms described below should be made based on the contents throughout this specification.

Also, throughout this specification, when a part "includes" a component, it does not mean that it excludes other components, but rather that it may include other components.

Additionally, terms such as processor described in the specification mean a unit that processes at least one function or operation, which may be implemented by hardware, software, or a combination of hardware and software.

Additionally, throughout the specification, when a part is said to be "connected" to another part, this includes not only cases where it is "directly connected," but also cases where it is "indirectly connected" with another element in between.

FIG. 1 is a block diagram showing an apparatus 100 for diagnosing a battery according to an embodiment of the present disclosure.

As illustrated in FIG. 1, an apparatus 100 for diagnosing a battery according to an embodiment of the present disclosure includes a voltage determining unit 110, a selecting unit 120, a calculating unit 130, and a diagnosing unit 140. In an embodiment, the apparatus 100 for diagnosing a battery according to the present disclosure may further include at least one of a management control unit 150, an information processing unit 160, an area determining unit 170, and a history information storage unit 180.

The battery 50 corresponding to the diagnostic target of the present disclosure may be a battery cell, which is the minimum unit of charging and discharging, or a battery bank, a battery module, or a battery pack in which a plurality of battery cells are connected in series and/or in parallel.

Hereinafter, in order to increase the efficiency of explanation and ease of understanding, the battery 50 is described as meaning an independent battery cell having a positive electrode and a negative electrode. For example, the battery 50 may be a lithium-ion battery or a lithium polymer battery.

In addition, the battery 50 may be implemented in various forms. For example, the battery 50 may be implemented in a cylindrical type, a prismatic type, or a pouch type.

Among the components of the apparatus 100 for diagnosing a battery according to the present disclosure, the voltage determining unit 110 is configured to determine an electrical feature value including an OCV of the target battery 50 through a measuring means electrically connected to a battery 50 to be diagnosed (hereinafter referred to as "target battery"). The measuring means may be implemented as various known measuring means as long as it may measure the OCV of the target battery 50.

In order to improve the accuracy of data processing and more precisely analyze the correlation between the positive electrode profile, the negative electrode profile and the battery profile of the target battery 50, the voltage determining unit 110 may measure the OCV (Open Circuit Voltage) of the target battery 50.

As will be explained again below, the positive electrode profile is a profile representing the corresponding relationship between the positive electrode capacity and the positive electrode voltage (or, positive electrode potential) of the target battery 50. The negative electrode profile is a profile representing the corresponding relationship between the negative electrode capacity and the negative electrode voltage (or, negative electrode potential) of the target battery 50. The battery profile is a profile representing the corresponding relationship between the capacity and voltage of the target battery 50.

The selecting unit 120 is configured to select a positive electrode capacity corresponding to the OCV of the target battery 50 using the positive electrode profile of the target battery 50, and to select a negative electrode capacity corresponding to the OCV of the target battery 50 using the negative electrode profile of the target battery 50.

The calculating unit 130 is configured to calculate the positive electrode depth, which is a ratio of the selecting positive electrode capacity to the positive electrode entire capacity of the target battery 50, and the negative electrode depth, which is a ratio of the selecting negative electrode capacity to the negative electrode entire capacity of the target battery 50, when the positive electrode capacity and the negative electrode capacity are respectively selected by the selecting unit 120.

The diagnosing unit 140 is configured to diagnose the state of the target battery 50 based on at least one of the positive electrode depth and the negative electrode depth.

For example, the diagnosing unit 140 may be configured to diagnose the state of the target battery 50 as a degradation state when the positive electrode depth is less than or equal to a predetermined first reference value, when the negative electrode depth is less than or equal to a predetermined second reference value, or both.

In an embodiment, the apparatus 100 for diagnosing a battery may further include a management control unit 150. The management control unit 150 may be configured to control a usage condition of the target battery 50 when the positive electrode depth is less than or equal to the first reference value, when the negative electrode depth is less than or equal to the second reference value, or both.

For example, the management control unit 150 may control a charger for charging the target battery 50 or a discharger for discharging the target battery 50 to limit a current rate for charging or discharging the target battery 50 or reduce a voltage when the target battery 50 is fully charged. According to an embodiment, the management control unit 150 may be configured to control a predetermined cooling device to cool the target battery 50.

FIG. 2 is a block diagram showing a selecting unit 120 of the apparatus for diagnosing a battery shown in FIG. 1.

As illustrated in FIG. 2, the selecting unit 120 may include, as detailed components, a profile obtaining unit 121, a reference storage unit 123, a profile determining unit 125, and a feature value selecting unit 127.

The profile obtaining unit 121 is configured to obtain a battery profile BP representing a corresponding relationship between the voltage and capacity (or, SOC) of the target battery 50.

In an embodiment, the profile obtaining unit 121 may measure electrical feature values, such as voltage and current, of the target battery 50 using a known measuring means before obtaining the battery profile BP.

In this case, the profile obtaining unit 121 may obtain the battery profile BP by calculating the capacity or SOC (State of Charge) of the target battery 50 corresponding to the voltage of the target battery 50 based on the measured electrical feature value. For example, the battery profile BP may be a data set in which the voltage value and the capacity value (or SOC) of the target battery 50 measured at the same time are mapped.

In another embodiment, the profile obtaining unit 121 may obtain the battery profile BP by reading the battery profile BP stored in advance in a predetermined memory, or by receiving the battery profile BP from a separate device capable of communicating with the apparatus 100 for diagnosing a battery.

Meanwhile, the SOC of the battery is a parameter that indicates the current capacity relative to the maximum capacity as 0 to 1, or 0% to 100%, and various techniques and technologies such as current integration, equivalent circuit model, and Kalman filter may be applied to generate data on the SOC. Depending on the embodiment, information on the SOC may be generated by further reflecting environmental information such as temperature information.

The profile determining unit 125 may determine a positive electrode profile and a negative electrode profile corresponding to the battery profile BP by adjusting a predetermined reference positive electrode profile and a predetermined reference negative electrode profile to correspond to the battery profile BP.

The reference positive electrode profile is a profile representing the corresponding relationship between the positive electrode capacity and the positive electrode voltage (or, positive electrode potential) of a predetermined reference battery. The reference negative electrode profile is a profile representing the corresponding relationship between the negative electrode capacity and the negative electrode voltage (or, negative electrode potential) of the reference battery.

Here, the reference battery is a battery with the same specifications as the target battery 50, and may be a battery at the BOL (Beginning Of Life) point or an ideal battery according to the design.

The reference positive electrode profile and the reference negative electrode profile may be curves displayed on a coordinate system having a horizontal axis (X-axis) representing capacity or SOC and a vertical axis (Y-axis) representing voltage, respectively, or may be functions or data sets corresponding to these curves.

In an embodiment, the reference positive electrode profile and the reference negative electrode profile may be generated based on voltage values for each capacity of the positive electrode or negative electrode measured while charging or discharging a 3-electrode cell or a half-cell, respectively.

Meanwhile, the reference positive electrode profile and the reference negative electrode profile may be stored in advance in the reference storage unit 123. In this case, the reference storage unit 123 may be configured to provide the pre-stored reference positive electrode profile and the reference negative electrode profile to the profile determining unit 125.

In addition, the positive electrode profile corresponding to the battery profile BP is a profile representing the corresponding relationship between the positive electrode capacity and the positive electrode voltage (or, positive electrode potential) of the target battery 50. The negative electrode profile corresponding to the battery profile BP is a profile representing the corresponding relationship between the negative electrode capacity and the negative electrode voltage (or, negative electrode potential) of the target battery 50.

The feature value selecting unit 127 may select a positive electrode voltage corresponding to the OCV determined by the voltage determining unit 110 in the positive electrode profile, and select a positive electrode capacity corresponding to the selected positive electrode voltage.

Additionally, the feature value selecting unit 127 may select a negative electrode voltage corresponding to the OCV determined by the voltage determining unit 110 in the negative electrode profile, and select a negative electrode capacity corresponding to the selected negative electrode voltage.

As a result, the calculating unit 130 may calculate the positive electrode depth, which is the ratio of the selecting positive electrode capacity to the positive electrode entire capacity of the target battery 50 as described above, and the negative electrode depth, which is the ratio of the selecting negative electrode capacity to the negative electrode entire capacity of the target battery 50.

The selecting unit 120 described above may be implemented by a combination of hardware such as a processor, memory, etc., and software such as a program executed by the processor. In this case, the profile obtaining unit 121, the reference storage unit 123, the profile determining unit 125, and the feature value selecting unit 127 of the selecting unit 120 may be functionally or logically distinct components rather than physically distinct components.

Referring back to FIG. 1, the voltage determining unit 110 may be configured to determine a first OCV, which is the OCV at the charge end of the target battery 50, and a second OCV, which is the OCV at the discharge end of the target battery 50.

After the discharge of the battery is completed, if a rest period of several minutes to several tens of minutes has passed, the polarization phenomenon inside the battery stabilizes. As a result, the voltage between the positive electrode and the negative electrode of the battery becomes slightly higher than the voltage at the end of discharge, and converges to a voltage value called 'OCV at the end of discharge' (EoD OCV, End of Discharge OCV) in this specification.

Therefore, the voltage determining unit 110 may determine the OCV of the target battery 50, which is measured several tens of minutes (e.g., 30 minutes) after the discharge of the target battery 50 is terminated, as the OCV at the end of discharge (EoD OCV). According to an embodiment, the OCV at the end of discharge (EoD OCV) may be estimated from a voltage value measured at another point in time based on a known estimation technique.

In addition, after the battery charging is completed, if a rest period of several minutes to several tens of minutes has passed, the voltage between the two terminals of the battery becomes slightly lower than the voltage at the end of the charge, and converges to a voltage value called 'OCV at the end of charge' (EoC OCV, End of Charge OCV) in this specification.

Therefore, the voltage determining unit 110 may determine the voltage measured several tens of minutes (e.g., 30 minutes) after the end of charge of the target battery 50 as the OCV at the end of charge (EoC OCV).

As will be explained again below, as the number of charge and discharge cycles increases and the battery gradually degrades, the OCV at the end of the charge (EoC OCV) and the OCV at the end of the discharge (EoD OCV) of the battery exhibit time-series changing behavioral characteristics. These behavioral characteristics suggest that the OCV at the end of the charge (EoC OCV) and the OCV at the end of the discharge (EoD OCV) are closely related to the degradation of the battery.

The present disclosure is a technical idea that takes advantage of these characteristic changes, and uses the OCV at the charge end (EoC OCV) and the OCV at the discharge end (EoD OCV) as diagnostic parameters to accurately diagnose the degradation state of the battery by distinguishing the degradation state for each electrode of the battery and using a quantitative value.

To this end, the feature value selecting unit 127 of the selecting unit 120 may select a positive electrode charging capacity, which is a positive electrode capacity corresponding to the first OCV, and a positive electrode discharging capacity, which is a positive electrode capacity corresponding to the second OCV, in the positive electrode profile.

In addition, the feature value selecting unit 127 of the selecting unit 120 may select a negative electrode charging capacity, which is a negative electrode capacity corresponding to the first OCV, and a negative electrode discharging capacity, which is a negative electrode capacity corresponding to the second OCV, in the negative electrode profile.

Then, the calculating unit 130 may calculate at least one of the positive electrode charging depth, which is the ratio of the positive electrode charging capacity to the positive electrode entire capacity of the target battery 50, and the positive electrode discharging depth, which is the ratio of the positive electrode discharging capacity to the positive electrode entire capacity, as the positive electrode depth.

In addition, the calculating unit 130 may calculate at least one of the negative electrode charging depth, which is a ratio of the negative electrode charging capacity to the negative electrode entire capacity of the target battery 50, and the negative electrode discharging depth, which is a ratio of the negative electrode discharging capacity to the negative electrode entire capacity, as the negative electrode depth.

For example, the positive electrode entire capacity of the target battery 50 may be calculated as in the formula 1.

[Formula 1]

$$C_{CT} = R_C \times ps \times A_C \text{ [Ah]}$$

In the formula 1, $C_{CT}$ represents the positive electrode entire capacity, $R_C$ represents the reference positive electrode capacity per unit area, ps represents the shrinkage rate of the positive electrode profile of the target battery with respect to the reference positive electrode profile, and $A_C$ represents the positive electrode area of the target battery.

In addition, the negative electrode entire capacity of the target battery 50 may be calculated as in the formula 2.

[Formula 2]

$$C_{AT} = R_A \times ns \times A_A \text{ [Ah]}$$

In the formula 2, $C_{AT}$ represents the negative electrode entire capacity, $R_A$ represents the reference negative electrode capacity per unit area, ns represents the shrinkage rate of the negative electrode profile of the target battery with respect to the reference negative electrode profile, and $A_A$ represents the negative electrode area of the target battery.

Additionally, the positive electrode charging depth may be calculated as in the formula 3.

[Formula 3]

$$D_{CC} = (C_{CC} \div C_{CT}) \times 100 \text{ [\%]}$$

In the formula 3, $D_{CC}$ is the positive electrode charging depth, $C_{CT}$ is the positive electrode entire capacity, and Ccc is the positive electrode charging capacity.

Additionally, the positive electrode discharging depth may be calculated as in the formula 4.

[Formula 4]

$$D_{CD} = (C_{CD} \div C_{CT}) \times 100 \text{ [\%]}$$

In the formula 4, $D_{CD}$ is the positive electrode discharging depth, $C_{CT}$ is the positive electrode entire capacity, and $C_{CD}$ is the positive electrode discharging capacity.

Additionally, the negative electrode charging depth may be calculated as in the formula 5.

[Formula 5]

$$D_{AC} = (C_{AC} \div C_{AT}) \times 100 \text{ [\%]}$$

In the formula 5, $D_{AC}$ is the negative electrode charging depth, $C_{AT}$ is the negative electrode entire capacity, and $C_{AC}$ is the negative electrode charging capacity.

Additionally, the negative electrode discharging depth may be calculated as in the formula 6.

[Formula 6]

$$D_{AD} = (C_{AD} \div C_{AT}) \times 100 \text{ [\%]}$$

In the formula 6, $D_{AD}$ is the negative electrode discharging depth, $C_{AT}$ is the negative electrode entire capacity, and $C_{AD}$ is the negative electrode discharging capacity.

The diagnosing unit 140 may diagnose the state of the target battery 50 based on at least one of the positive electrode charging depth and the positive electrode discharging depth corresponding to the positive electrode depth of the target battery 50, and the negative electrode charging depth and the negative electrode discharging depth corresponding to the negative electrode depth of the target battery 50.

In an embodiment, the diagnosing unit 140 may diagnose whether the positive electrode of the target battery 50 is degraded based on at least one of the positive electrode charging depth and the positive electrode discharging depth of the target battery 50.

For example, the diagnosing unit 140 may diagnose that the positive electrode of the target battery 50 is degraded when the positive electrode charging depth is less than or equal to a predetermined first charging depth reference value, when the positive electrode discharging depth is less than or equal to a predetermined first discharging depth reference value, or when both are true.

Additionally, the diagnosing unit 140 may diagnose whether the negative electrode of the target battery 50 is degraded based on at least one of the negative electrode charging depth and the negative electrode discharging depth of the target battery 50.

For example, the diagnosing unit 140 may diagnose that the negative electrode of the target battery 50 is degraded when the negative electrode charging depth is less than or equal to a predetermined second charging depth reference value, when the negative electrode discharging depth is less than or equal to a predetermined second discharging depth reference value, or when both are true.

In an embodiment, the diagnosing unit 140 may be configured to generate diagnostic data representing a degradation state of the target battery 50 based on at least one of the positive electrode charging depth, the positive electrode discharging depth, the negative electrode charging depth, and the negative electrode discharging depth.

In an embodiment, the apparatus 100 for diagnosing a battery according to the present disclosure may further include an information processing unit 160. In this case, the information processing unit 160 may be configured to provide data regarding the positive electrode entire capacity and the negative electrode entire capacity of the target battery 50 to the calculating unit 130. To this end, the information processing unit 160 may be configured to store data regarding the positive electrode entire capacity and the negative electrode entire capacity in advance.

In another embodiment, the information processing unit 160 may be configured to pre-store the values of the positive electrode entire capacity and the negative electrode entire capacity at the BOL (Beginning Of Life) time of the target battery 50 as reference values, and to correct the corresponding reference values as the number of cycles increases, thereby calculating the values of the positive electrode entire capacity and the negative electrode entire capacity corresponding to the number of cycles during which diagnosis is performed on the target battery 50.

For example, the information processing unit 160 may be configured to update the values of the positive electrode entire capacity and the negative electrode entire capacity of the target battery 50 using the formula 1 and the formula 2 when a predetermined number of cycles arrives. Note that the values of the parameters ps of the formula 1 and the parameters ns of the formula 2 may change as the number of cycles increases.

In an embodiment, the apparatus 100 for diagnosing a battery according to the present disclosure may further include an area determining unit 170. In this case, the area determining unit 170 may be configured to determine a first area, which is an area of capacity not included in the positive electrode charging capacity and the positive electrode discharging capacity among the positive electrode entire capacity, and to determine a second area, which is an area of capacity not included in the negative electrode charging capacity and the negative electrode discharging capacity among the negative electrode entire capacity. In this case, the first area corresponds to an unused area of the positive electrode, and the second area corresponds to an unused area of the negative electrode.

Once the unused area is determined in this way, the diagnosing unit 140 may determine whether the size difference between the first area and the second area is greater than or equal to a threshold value. The size difference between the first area and the second area may represent the difference between the available capacity of the positive electrode and the available capacity of the negative electrode.

Therefore, if the size difference between the first area and the second area is greater than or equal to the threshold value, the diagnosing unit 140 may diagnose that the positive electrode and the negative electrode of the target battery 50 are in an unbalanced degraded state.

In this case, the management control unit 150 may control the usage condition or usage environment of the target battery 50, such as lowering the current rate for charging and/or discharging the target battery 50, or limiting the upper or lower voltage limit when charging or discharging the target battery 50.

In an embodiment, the apparatus 100 for diagnosing a battery according to the present disclosure may further include a history information storage unit 180. In this case, the history information storage unit 180 may generate and store history information that interrelates diagnostic data generated by the diagnosing unit 140, identification information of the target battery 50 and time information at which the diagnostic data is generated.

Meanwhile, the apparatus 100 for diagnosing a battery according to the present disclosure may be implemented through various combinations of electronic devices and electrical parts such as a storage means, a calculating processing means, an input/output means, an ASIC, a chipset, a register, a communication modem, etc. Accordingly, the components of the apparatus 100 for diagnosing a battery illustrated in FIG. 1 should be understood as functionally or logically distinct components rather than physically distinct components.

That is, since each component of the apparatus 100 for diagnosing a battery illustrated in FIG. 1 corresponds to a functional configuration for effectively explaining the technical idea according to the present disclosure, even if each component is separated into subcomponents or integrated with other components, if the corresponding function can be realized, it should be interpreted as being within the scope of the present disclosure. In addition, a component that performs the same or similar function as a component of the present disclosure should be interpreted as being within the scope of the present disclosure regardless of whether their names match.

The apparatus 100 for diagnosing a battery according to the present disclosure is a device configured to diagnose the state of battery 50, and may be configured to be linked with other devices, terminals, servers, etc. according to an embodiment. In this case, the apparatus 100 for diagnosing a battery according to the present disclosure may be configured to generate diagnostic data for the target battery 50 and transmit it to a user terminal, a control server, or an output device of a vehicle.

FIG. 3 is a flow chart showing a method for diagnosing a battery according to an embodiment of the present disclosure. Referring to FIG. 3, the functions and operations of the apparatus 100 for diagnosing a battery described above are explained in time series. The apparatus for diagnosing a battery according to the present disclosure may be implemented by a combination of a processor and a program executed by the processor. That is, the method for diagnosing a battery according to the present disclosure may be executed by a processor.

As illustrated in FIG. 3, the voltage determining unit 110 of the apparatus 100 for diagnosing a battery measures the OCV of the target battery 50 through a measuring means electrically connected to the target battery (S300).

In this case, the voltage determining unit 110 may determine the first OCV, which is the OCV at the charge end of the target battery 50, and the second OCV, which is the OCV at the discharge end of the target battery 50.

Next, the selecting unit 120 of the apparatus 100 for diagnosing a battery selects a positive electrode capacity corresponding to the OCV of the target battery 50 using the positive electrode profile of the target battery 50, and selects a negative electrode capacity corresponding to the OCV of the target battery 50 using the negative electrode profile of the target battery 50 (S310).

The positive electrode profile is a profile representing the corresponding relationship between the positive electrode capacity and the positive electrode voltage (or, positive electrode potential) of the target battery 50. The negative electrode profile is a profile representing the corresponding relationship between the negative electrode capacity and the negative electrode voltage (or, negative electrode potential) of the target battery 50.

For example, the selecting unit 120 may select, in the positive electrode profile, a positive electrode charging capacity, which is a positive electrode capacity corresponding to the first OCV, and a positive electrode discharging capacity, which is a positive electrode capacity corresponding to the second OCV.

Additionally, the selecting unit 120 may select, in the negative electrode profile, a negative electrode charging capacity, which is a negative electrode capacity corresponding to the first OCV, and a negative electrode discharging capacity, which is a negative electrode capacity corresponding to the second OCV.

Then, the calculating unit 130 of the apparatus 100 for diagnosing a battery calculates a positive electrode depth, which is a ratio of the selected positive electrode capacity to the positive electrode entire capacity of the target battery 50, and a negative electrode depth, which is a ratio of the selected negative electrode capacity to the negative electrode entire capacity of the target battery 50, when the positive electrode capacity and the negative electrode capacity are respectively selected by the selecting unit 120 (S320).

For example, the calculating unit 130 may calculate at least one of the positive electrode charging depth, which is the ratio of the positive electrode charging capacity to the positive electrode entire capacity of the target battery 50, and the positive electrode discharging depth, which is the ratio of the positive electrode discharging capacity to the positive electrode entire capacity, as the positive electrode depth.

In addition, the calculating unit 130 may calculate at least one of the negative electrode charging depth, which is a ratio of the negative electrode charging capacity to the negative electrode entire capacity of the target battery 50, and the negative electrode discharging depth, which is a ratio of the negative electrode discharging capacity to the negative electrode entire capacity, as the negative electrode depth.

Next, the diagnosing unit 140 of the apparatus 100 for diagnosing a battery diagnoses the state of the target battery 50 based on at least one of the positive electrode depth and the negative electrode depth (S330).

The diagnosing unit 140 may diagnose the state of the target battery 50 as a degradation state when the positive electrode depth is less than or equal to a predetermined first reference value, when the negative electrode depth is less than or equal to a predetermined second reference value, or when both are true (S340).

For example, the diagnosing unit 140 may diagnose the state of the target battery 50 based on at least one of the positive electrode charging depth, the positive electrode discharging depth, the negative electrode charging depth, and the negative electrode discharging depth described above.

In an embodiment, the diagnosing unit 140 may diagnose whether the positive electrode of the target battery 50 is degraded based on at least one of the positive electrode charging depth and the positive electrode discharging depth included in the positive electrode depth of the target battery 50. For example, the diagnosing unit 140 may diagnose that the positive electrode of the target battery 50 is degraded when the positive electrode charging depth is equal to or less than a predetermined first charging depth reference value, when the positive electrode discharging depth is equal to or less than a predetermined first discharging depth reference value, or when both are true.

In addition, the diagnosing unit 140 may diagnose whether the negative electrode of the target battery 50 is degraded based on at least one of the negative electrode charging depth and the negative electrode discharging depth included in the negative electrode depth of the target battery 50. For example, the diagnosing unit 140 may diagnose that the negative electrode of the target battery 50 is degraded when the negative electrode charging depth is equal to or lower than a predetermined second charging depth reference value, when the negative electrode discharging depth is equal to or lower than a predetermined second discharging depth reference value, or when both are true.

Next, the management control unit 150 of the apparatus 100 for diagnosing a battery may control the usage condition or usage environment of the target battery 50 if the state of the target battery 50 is diagnosed as a degradation state (S350).

For example, the management control unit 150 may control a charger for charging the target battery 50 or a discharger for discharging the target battery 50 to limit a current rate for charging or discharging the target battery 50 or reduce a voltage when the target battery 50 is fully charged. According to an embodiment, the management control unit 150 may also control a predetermined cooling device to cool the target battery 50.

The apparatus 100 for diagnosing a battery may repeat the above-described steps (S300 to S350) until a predetermined termination condition is met (S360). In this case, the termination condition may include a termination command of a user, discontinuation of use of the battery, disconnection of the electrical connection with the battery, etc.

FIG. 4 is a flow chart showing a process for determining an unused area of a battery in a method for diagnosing a battery according to an embodiment of the present disclosure.

As illustrated in FIG. 4, the calculating unit 130 of the apparatus 100 for diagnosing a battery selects the positive electrode charging capacity, the positive electrode discharging capacity, the negative electrode charging capacity, and the negative electrode discharging capacity of the target battery 50 described above (S400).

Next, the area determining unit 170 of the apparatus 100 for diagnosing a battery selects a first area, which is an area of capacity not included in the positive electrode charging capacity and the positive electrode discharging capacity among the positive electrode entire capacity of the target battery 50 (S410).

In addition, the area determining unit 170 selects a second area, which is an area of capacity not included in the negative electrode charging capacity and the negative electrode discharging capacity among the negative electrode entire capacity of the target battery 50 (S420).

Since the first area and the second area are mutually independent parameters, unlike the example illustrated in FIG. 4, the step (S420) of selecting the second area may precede the step (S410) of selecting the first area, or these steps may be performed simultaneously.

Next, the area determining unit 170 determines the first area and the second area as unused areas of the target battery 50, respectively (S430).

Once the unused area is determined in this way, the diagnosing unit 140 may determine whether the size difference between the first area and the second area is greater than or equal to a predetermined threshold value (S440).

The size difference between the first area and the second area may represent the difference between the available capacity of the positive electrode and the available capacity of the negative electrode. Therefore, when the size difference between the first area and the second area is greater or equal to than the threshold value, the diagnosing unit 140 may diagnose the state of the target battery 50 as a state in which the positive electrode and the negative electrode are unbalancedly degraded (S450).

In this case, the management control unit 150 of the apparatus 100 for diagnosing a battery may control the usage condition or usage environment of the target battery 50, such as lowering the current rate for charging and/or discharging the target battery 50 or limiting the voltage when the target battery 50 is fully charged.

In addition, the history information storage unit 180 of the apparatus 100 for diagnosing a battery may generate and store history information that interrelates the diagnostic data generated by the diagnosing unit 140 with the identification information of the target battery 50 and the time information at which the diagnostic data is generated.

FIG. 5 is a flow chart showing a process for calculating a positive electrode capacity and a negative electrode capacity in the method for diagnosing a battery according to an embodiment of the present disclosure.

As illustrated in FIG. 5, the selecting unit 120 of the apparatus 100 for diagnosing a battery measures electrical feature values, such as voltage and current, of the target battery 50 using a known measuring means to determine a positive electrode profile and a negative electrode profile of the target battery 50 (S500).

Next, the selecting unit 120 generates a battery profile representing a corresponding relationship between the capacity (or SOC) and voltage of the target battery 50 based on the measured electrical feature values (S510). In this case, the battery profile may be a data set in which voltage values and capacity values (or SOC values) of the target battery 50 measured at the same time are mapped.

Next, the selecting unit 120 determines the positive electrode profile and the negative electrode profile of the target battery 50 by adjusting the predetermined reference positive electrode profile and the predetermined reference negative electrode profile to correspond to the battery profile (S520).

As described above, the reference positive electrode profile is a profile representing the corresponding relationship between the positive electrode capacity and the positive electrode voltage (or, positive electrode potential) of a predetermined reference battery. The reference negative electrode profile is a profile representing the corresponding relationship between the negative electrode capacity and the negative electrode voltage (or, negative electrode potential) of the reference battery.

Here, the reference battery is a battery with the same specifications as the target battery 50, and may be a battery at the BOL (Beginning Of Life) point or an ideal battery according to the design.

The reference positive electrode profile and the reference negative electrode profile may be curves displayed on a coordinate system having a horizontal axis (X-axis) representing capacity or SOC and a vertical axis (Y-axis) representing voltage, respectively, or may be functions or data sets corresponding to these curves.

In addition, the positive electrode profile of the target battery 50 is a profile representing the corresponding relationship between the positive electrode capacity and the positive electrode voltage (or, positive electrode potential) of the target battery 50. The negative electrode profile of the target battery 50 is a profile representing the corresponding relationship between the negative electrode capacity and the negative electrode voltage (or, negative electrode potential) of the target battery 50.

Then, the selecting unit 120 selects, in the positive electrode profile, a positive electrode capacity corresponding to the first OCV, which is the OCV after the charge end of the target battery 50, as the positive electrode charging capacity, and selects a positive electrode capacity corresponding to the second OCV, which is the OCV after the discharge end of the target battery 50, as the positive electrode discharging capacity (S530).

Additionally, the selecting unit 120 selects, in the negative electrode profile, the negative electrode capacity corresponding to the first OCV as the negative electrode charging capacity, and selects the negative electrode capacity corresponding to the second OCV as the negative electrode discharging capacity (S540).

As a result, the calculating unit 130 of the apparatus 100 for diagnosing a battery may calculate the positive electrode depth, which is the ratio of the selecting positive electrode capacity to the positive electrode entire capacity of the target battery 50, and the negative electrode depth, which is the ratio of the selecting negative electrode capacity to the negative electrode entire capacity of the target battery 50, as described above.

Meanwhile, the embodiments according to the present disclosure may be implemented as a computer system and a computer program that operates the computer system. When the embodiments of the present disclosure are implemented as a computer program, the components of the present disclosure may include program segments that execute the corresponding operation or task through the corresponding computer system. These computer programs or program segments may be stored in various computer-readable recording media. The computer-readable recording media may include all types of media that record data readable by a computer system. For example, the computer-readable recording media may include a ROM, a RAM, an EEPROM, a register, a flash memory, a CD-ROM, a magnetic tape, a hard disk, a floppy disk, or an optical data recording device. In addition, these recording media may be distributed in various communication network-connected computer systems to store or execute program codes in a distributed manner.

FIG. 6 is a graph showing a change in the charge end voltage of a battery according to an increase in the number of cycles.

FIG. 6 shows the change characteristics of OCV at the end of charge (EoC OCV) in the first case where the charge and discharge SOC range is set to 0 to 100 (%), the second case where it is set to 20 to 100 (%), and the third case where it is set to 40 to 100 (%).

Also, in FIG. 6, V1 represents the OCV at the end of charge (EoC OCV) of the target battery 50 that has undergone 100 cycles.

FIG. 7 is a graph showing a change in the discharge end voltage of a battery according to an increase in the number of cycles.

FIG. 7 shows the change characteristics of OCV at the end of discharge (EoD OCV) in the first case where the charge and discharge SOC range is set to 0 to 100 (%), the second case where it is set to 20 to 100 (%), and the third case where it is set to 40 to 100 (%), respectively.

Also, in FIG. 7, V2 represents the OCV at the end of discharge (EoD OCV) of the target battery 50 that has undergone 100 cycles.

As shown in FIGS. 6 and 7, the OCV at the charge end (EoC OCV) and the OCV at the discharge end (EoD OCV) of the battery have behavioral characteristics that change over time as the number of cycles increases and the battery degrades. These behavioral characteristics suggest that the OCV at the charge end (EoC OCV) and the OCV at the discharge end (EoD OCV) are closely related to the degradation of the battery.

The present disclosure is a technical idea that takes advantage of these characteristic changes, and by using the OCV at the charge end (EoC OCV) and the OCV at the discharge end (EoD OCV) as parameters, the degradation of the battery, specifically the degradation of the charge characteristics of each electrode of the battery and the degradation of the discharge characteristics, may be accurately diagnosed by separating them into quantifiable figures.

FIG. 8 is a drawing showing an example of a positive electrode profile of a battery.

In FIG. 8, the voltage indicated as V1p is the voltage of the positive electrode corresponding to the first OCV (V1) (hereinafter referred to as the 'first positive electrode voltage'), and the capacity of the positive electrode corresponding to the first positive electrode voltage (V1p) in the positive electrode profile of the target battery 50 corresponds to the positive electrode charging capacity (Ccc).

In addition, in FIG. 8, the voltage indicated as V2p is the voltage of the positive electrode corresponding to the second OCV (V2) (hereinafter referred to as the 'second positive electrode voltage'), and the capacity of the positive electrode corresponding to the second positive electrode voltage (V2p) in the positive electrode profile of the target battery 50 corresponds to the positive electrode discharging capacity ($C_{CD}$).

FIG. 9 is a drawing showing an example of a negative electrode profile of a battery.

In FIG. 9, the voltage indicated as V1n is the voltage of the negative electrode corresponding to the first OCV (V1) (hereinafter referred to as the 'first negative electrode voltage'), and the capacity of the negative electrode corresponding to the first negative electrode voltage (V1n) in the negative electrode profile of the target battery 50 corresponds to the negative electrode charging capacity ($C_{AC}$).

In addition, in FIG. 9, the voltage indicated as V2n is the voltage of the negative electrode corresponding to the second OCV (V2) (hereinafter referred to as the 'second negative electrode voltage'), and the capacity of the negative electrode corresponding to the second negative electrode voltage (V2n) in the negative electrode profile of the target battery 50 corresponds to the negative electrode discharging capacity ($C_{AD}$).

FIG. 10 is a graph showing changes in a positive electrode charging depth and a positive electrode discharging depth of a battery according to an increase in the cumulative driving distance of an electric vehicle using the battery.

In FIG. 10, three lines Lc1 to Lc3 shown in the upper part in a mutually overlapping form represent the positive electrode charging depth, and three lines Lc4 to Lc6 shown in the lower part represent the positive electrode discharging depth.

Also, among the lines Lc1 to Lc6, Lc1 and Lc4 are cases where the charge and discharge SOC range is set to 40 to 100 (%), Lc2 and Lc5 are cases where the charge and discharge SOC range is set to 20 to 100 (%), and Lc3 and Lc6 are cases where the charge and discharge SOC range is set to 0 to 100 (%).

FIG. 11 is a graph showing changes in a negative electrode charging depth and a negative electrode discharging depth of a battery according to an increase in the cumulative driving distance of an electric vehicle using the battery.

The three lines La1 to La3 shown in the upper part in a mutually overlapping form in FIG. 11 represent the negative electrode charging depth, and the three lines La4 to La6 shown in the lower part represent the negative electrode discharging depth.

Among the lines La1 to La6, La1 and La4 are cases where the charge and discharge SOC range is set to 40 to 100 (%), La2 and La5 are cases where the charge and discharge SOC range is set to 20 to 100 (%), and La3 and La6 are cases where the charge and discharge SOC range is set to 0 to 100 (%).

The horizontal axes of FIGS. 10 and 11 represent the cumulative capacity provided by the battery while the number of charge and discharge cycles of the battery increases, converted into a cumulative driving distance of the electric vehicle.

As shown in FIGS. 10 and 11, the positive electrode charging depth, the positive electrode discharging depth, the negative electrode charging depth, and the negative electrode discharging depth of the battery generally show a decreasing trend as the number of cycles increases.

However, as illustrated in FIG. 11, the negative electrode discharging depth (La6) may show an increasing trend as the number of cycles increases. In this case, the diagnosing unit 140 of the apparatus 100 for diagnosing a battery may diagnose the state of the battery based on whether the negative electrode discharging depth (La6) exceeds a predetermined reference value or is correlated with the negative electrode charging depth (La3).

FIG. 12 is a drawing showing an example of a battery profile BP.

In FIG. 12, the horizontal axis (X-axis) represents the capacity of the target battery 50, and the vertical axis (Y-axis) represents the voltage of the target battery 50.

As described with reference to FIG. 2, the profile determining unit 125 of the selecting unit 120 may determine the positive electrode profile and the negative electrode profile of the target battery 50 by adjusting a predetermined reference positive electrode profile and a predetermined reference negative electrode profile to correspond to the battery profile BP.

FIG. 13 is a drawing showing an example of a reference positive electrode profile Rp and a reference negative electrode profile Rn.

As illustrated in FIG. 13, the reference positive electrode profile Rp is a profile representing a corresponding relationship between the positive electrode capacity and the positive electrode voltage (or, positive electrode potential) of a predetermined reference battery. In addition, the reference negative electrode profile Rn is a profile representing a corresponding relationship between the negative electrode capacity and the negative electrode voltage (or, negative electrode potential) of a predetermined reference battery.

In this case, when the reference positive electrode profile Rp and the reference negative electrode profile Rn are combined, a reference battery profile R representing a corresponding relationship between the capacity and voltage of the reference battery may be generated. That is, the reference battery profile R may be generated by calculating the voltage difference by capacity between the reference positive electrode profile Rp and the reference negative electrode profile Rn in a capacity range corresponding to the SOC range from 0 (%) to 100 (%).

Meanwhile, the profile determining unit 125 may generate an adjustment positive electrode profile and an adjustment negative electrode profile by adjusting the position or shape of the reference positive electrode profile Rp and the reference negative electrode profile Rn, and may generate a comparison profile corresponding to the battery profile BP of the target battery 50 by mutually combining the adjustment positive electrode profile and the adjustment negative electrode profile.

For example, the profile determining unit 125 may generate a plurality of comparison profiles of different shapes by repeating the adjusting process and combining process for the reference positive electrode profile Rp and the reference negative electrode profile Rn.

The adjusting process may include at least one of shift, scaling, shrinkage and offset adjustment with respect to the reference positive electrode profile Rp and/or the reference negative electrode profile Rn.

Then, the profile determining unit 125 selects a comparison profile among the plurality of comparison profiles, which has a minimum error with respect to the battery profile BP, and may determine the adjustment positive electrode profile and the adjustment negative electrode profile used in generating the selected comparison profile as the positive electrode profile PP and the negative electrode profile NP of the target battery 50 (S520).

In this way, the present disclosure may diagnose the target battery in a nondestructive manner by generating a positive electrode profile and a negative electrode profile that estimate the current state of the target battery based on the reference positive electrode profile and the reference negative electrode profile.

FIG. 14 is a drawing showing an example of a positive electrode profile PP and a negative electrode profile NP of a battery.

As shown in FIG. 14, the positive electrode profile PP and the negative electrode profile NP of the target battery 50 may be determined by the profile determining unit 125 (S520).

Then, the feature value selecting unit 127 of the selecting unit 120 may select a first positive electrode voltage (V1p) and a second positive electrode voltage (V2p) corresponding to the first OCV (V1) and the second OCV (V2) of the battery profile BP in the positive electrode profile PP of the target battery 50, and select a positive electrode charging capacity (Ccc) corresponding to the first positive electrode voltage (V1p) and a positive electrode discharging capacity ($C_{CD}$) corresponding to the second positive electrode voltage (V2p).

In addition, the feature value selecting unit 127 may select a first negative electrode voltage (V1n) and a second negative electrode voltage (V2n) corresponding to the first OCV (V1) and the second OCV (V2) of the battery profile BP in the negative electrode profile NP of the target battery 50, and select a negative electrode charging capacity ($C_{AC}$) corresponding to the first negative electrode voltage (V1n) and a negative electrode discharging capacity ($C_{AD}$) corresponding to the second negative electrode voltage (V2n).

In an embodiment, the apparatus for diagnosing a battery according to the present disclosure may be included in a BMS (Battery Management System) that manages a battery module or a battery pack. That is, the BMS according to another aspect of the present disclosure includes the apparatus for diagnosing a battery according to the present disclosure.

A battery pack according to another aspect of the present disclosure comprises at least one battery and the apparatus for diagnosing a battery according to the present disclosure. In this case, each battery included in the battery pack may be a battery cell which is a basic unit of charging and discharging, or a battery module in which a plurality of battery cells are connected in series and/or in parallel.

A vehicle according to another aspect of the present disclosure comprises at least one battery and the apparatus for diagnosing a battery according to the present disclosure. In this case, each battery included in the vehicle may be a battery module having a plurality of battery cells connected in series and/or in parallel, or a battery pack having a plurality of battery cells or a plurality of battery modules connected in series and/or in parallel. The vehicle may further include an electric motor, an electronic control unit (ECU) for controlling the electric motor, or the like.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

The attached drawings, etc. for the purpose of explaining the present disclosure and illustrating examples thereof may be illustrated in a somewhat exaggerated form in order to emphasize or highlight the technical contents according to the present disclosure. However, it should be interpreted that it is obvious that various modified examples are possible at the level of a person skilled in the art by considering the contents described above and matters illustrated in the drawings.

In addition, terms such as 'first', 'second', etc. used in explaining the present disclosure are only terms used to relatively distinguish the components, and are not terms used to limit the order between the components.

[Explanation of reference symbols]

| | | | |
|---|---|---|---|
| 50: | battery | 100: | apparatus for diagnosing a battery |
| 110: | voltage determining unit | 120: | selecting unit |
| 121: | profile obtaining unit | 123: | reference storage unit |
| 125: | profile determining unit | 127: | feature value selecting unit |
| 130: | calculating unit | 140: | diagnosing unit |
| 150: | management control unit | 160: | information processing unit |
| 170: | area determining unit | 180: | history information storage unit |

## Claims

1. A method for diagnosing a battery, comprising:

    a voltage determining step of determining an OCV (Open Circuit Voltage) of a battery;
    a capacity selecting step of selecting a positive electrode capacity corresponding to the OCV from a positive electrode profile representing a corresponding relationship between the positive electrode capacity and a positive electrode voltage of the battery, and a negative electrode capacity corresponding to the OCV from a negative electrode profile representing a corresponding relationship between the negative electrode capacity and a negative electrode voltage of the battery;
    a depth calculating step of calculating a positive electrode depth, which is a ratio of the selected positive electrode capacity to a positive electrode entire capacity of the battery, and a negative electrode depth, which is a ratio of the selected negative electrode capacity to a negative electrode entire capacity of the battery; and
    a diagnosing step of diagnosing a state of the battery based on at least one of the positive electrode depth and the negative electrode depth.

2. The method for diagnosing a battery according to claim 1,

    wherein the voltage determining step includes a step of determining a first OCV, which is an OCV at a charge end of the battery, and a second OCV, which is an OCV at a discharge end of the battery,
    wherein the capacity selecting step includes a step of selecting a positive electrode charging capacity, which is a positive electrode capacity corresponding to the first OCV, and a positive electrode discharging capacity, which is a positive electrode capacity corresponding to the second OCV, in the positive electrode profile, and
    wherein the depth calculating step includes a step of calculating at least one of a positive electrode charging depth, which is a ratio of the positive electrode charging capacity to the positive electrode entire capacity, and a positive electrode discharging depth, which is a ratio of the positive electrode discharging capacity to the positive electrode entire capacity, as the positive electrode depth.

3. The method for diagnosing a battery according to claim 2,
wherein the diagnosing step includes a step of diagnosing whether a positive electrode of the battery is degraded based on at least one of the positive electrode charging depth and the positive electrode discharging depth.

4. The method for diagnosing a battery according to claim 1,

    wherein the voltage determining step includes a step of determining a first OCV, which is an OCV at a charge end of the battery, and a second OCV, which is an OCV at a discharge end of the battery,
    wherein the capacity selecting step includes a step of selecting a negative electrode charging capacity, which is a negative electrode capacity corresponding to the first OCV, and a negative electrode discharging capacity, which is a negative electrode capacity corresponding to the second OCV, in the negative electrode profile, and
    wherein the depth calculating step includes a step of calculating at least one of a negative electrode charging depth, which is a ratio of the negative electrode charging capacity to the negative electrode entire capacity, and a negative electrode discharging depth, which is a ratio of the negative electrode discharging capacity to the negative electrode entire capacity, as the negative electrode depth.

5. The method for diagnosing a battery according to claim 4,
wherein the diagnosing step includes a step of diagnosing whether a negative electrode of the battery is degraded based on at least one of the negative electrode charging depth and the negative electrode discharging depth.

6. The method for diagnosing a battery according to claim 1,
wherein the capacity selecting step includes:

    obtaining a battery profile representing a corresponding relationship between a voltage and a capacity of the battery;
    adjusting a predetermined reference positive electrode profile and a reference negative electrode profile to correspond to the battery profile to determine the positive electrode profile and the negative electrode profile; and
    selecting a positive electrode capacity corresponding to the OCV in the positive electrode profile, and selecting a negative electrode capacity corresponding to the OCV in the negative electrode profile.

7. The method for diagnosing a battery according to claim 1, wherein the diagnosing step includes:

diagnosing whether a positive electrode of the battery is degraded based on the positive electrode depth; and
diagnosing whether a negative electrode of the battery is degraded based on the negative electrode depth.

8. The method for diagnosing a battery according to claim 1, wherein the diagnosing step includes a step of diagnosing the state of the battery as a degradation state when the positive electrode depth is less than or equal to a predetermined first reference value, when the negative electrode depth is less than or equal to a predetermined second reference value, or when the positive electrode depth is less than or equal to the first reference value and the negative electrode depth is less than or equal to the second reference value.

9. The method for diagnosing a battery according to claim 1, further comprising: controlling a usage condition of the battery when the state of the battery is diagnosed as a degradation state.

10. An apparatus for diagnosing a battery, comprising:

a voltage determining unit configured to determine an OCV of a battery;
a selecting unit configured to select a positive electrode capacity corresponding to the OCV from a positive electrode profile representing a corresponding relationship between the positive electrode capacity and a positive electrode voltage of the battery, and a negative electrode capacity corresponding to the OCV from a negative electrode profile representing a corresponding relationship between the negative electrode capacity and a negative electrode voltage of the battery;
a calculating unit configured to calculate a positive electrode depth, which is a ratio of the selected positive electrode capacity to a positive electrode entire capacity of the battery, and a negative electrode depth, which is a ratio of the selected negative electrode capacity to a negative electrode entire capacity of the battery; and
a diagnosing unit configured to diagnose a state of the battery based on at least one of the positive electrode depth and the negative electrode depth.

11. The apparatus for diagnosing a battery according to claim 10,

wherein the voltage determining unit is configured to determine a first OCV, which is an OCV at a charge end of the battery, and a second OCV, which is an OCV at a discharge end of the battery,
wherein the selecting unit is configured to select a positive electrode charging capacity, which is a positive electrode capacity corresponding to the first OCV, and a positive electrode discharging capacity, which is a positive electrode capacity corresponding to the second OCV, in the positive electrode profile, and
wherein the calculating unit is configured to calculate at least one of a positive electrode charging depth, which is a ratio of the positive electrode charging capacity to the positive electrode entire capacity, and a positive electrode discharging depth, which is a ratio of the positive electrode discharging capacity to the positive electrode entire capacity, as the positive electrode depth.

12. The apparatus for diagnosing a battery according to claim 10,

wherein the voltage determining unit is configured to determine a first OCV, which is an OCV at a charge end of the battery, and a second OCV, which is an OCV at a discharge end of the battery,
wherein the selecting unit is configured to select a negative electrode charging capacity, which is a negative electrode capacity corresponding to the first OCV, and a negative electrode discharging capacity, which is a negative electrode capacity corresponding to the second OCV, in the negative electrode profile, and
wherein the calculating unit is configured to calculate at least one of a negative electrode charging depth, which is a ratio of the negative electrode charging capacity to the negative electrode entire capacity, and a negative electrode discharging depth, which is a ratio of the negative electrode discharging capacity to the negative electrode entire capacity, as the negative electrode depth.

13. The apparatus for diagnosing a battery according to claim 10, wherein the diagnosing unit is configured to diagnose whether a positive electrode of the battery is degraded based on the positive electrode depth, and diagnose whether a negative electrode of the battery is degraded based on the negative electrode depth.

**14.** A battery pack comprising the apparatus for diagnosing a battery according to any one of claims 10 to 13.

**15.** A vehicle comprising the apparatus for diagnosing a battery according to any one of claims 10 to 13.

FIG. 1

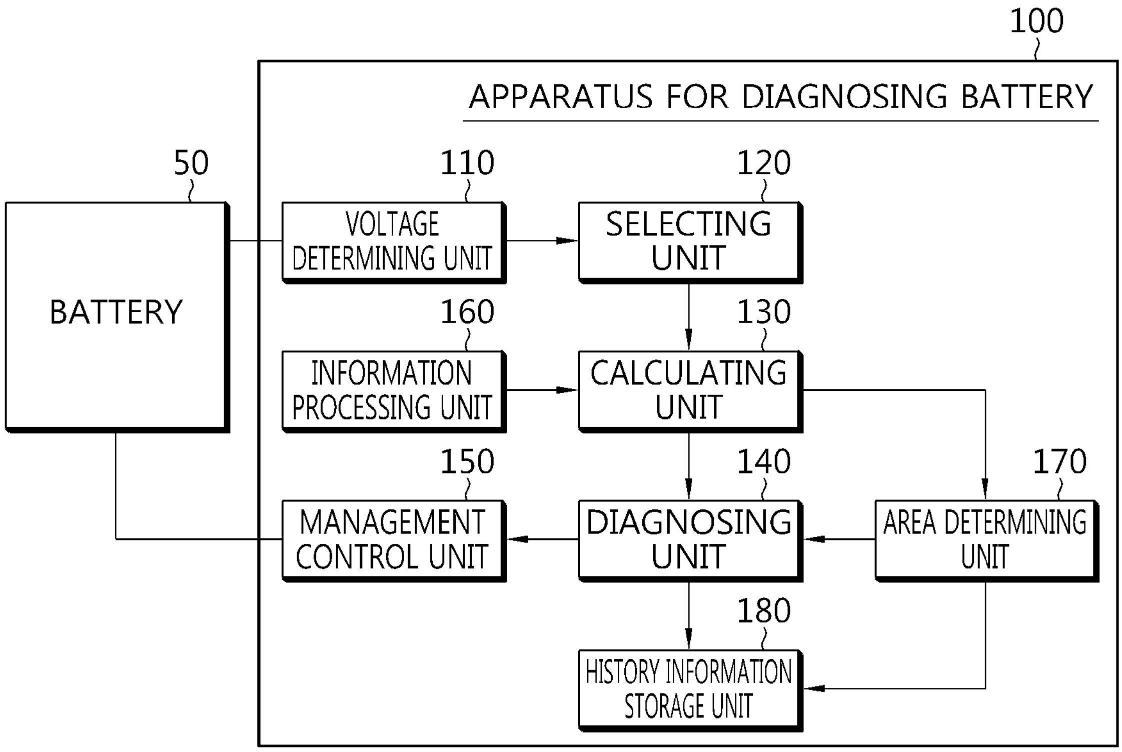
100
APPARATUS FOR DIAGNOSING BATTERY
50
BATTERY
110
VOLTAGE DETERMINING UNIT
120
SELECTING UNIT
160
INFORMATION PROCESSING UNIT
130
CALCULATING UNIT
150
MANAGEMENT CONTROL UNIT
140
DIAGNOSING UNIT
170
AREA DETERMINING UNIT
180
HISTORY INFORMATION STORAGE UNIT

FIG. 2

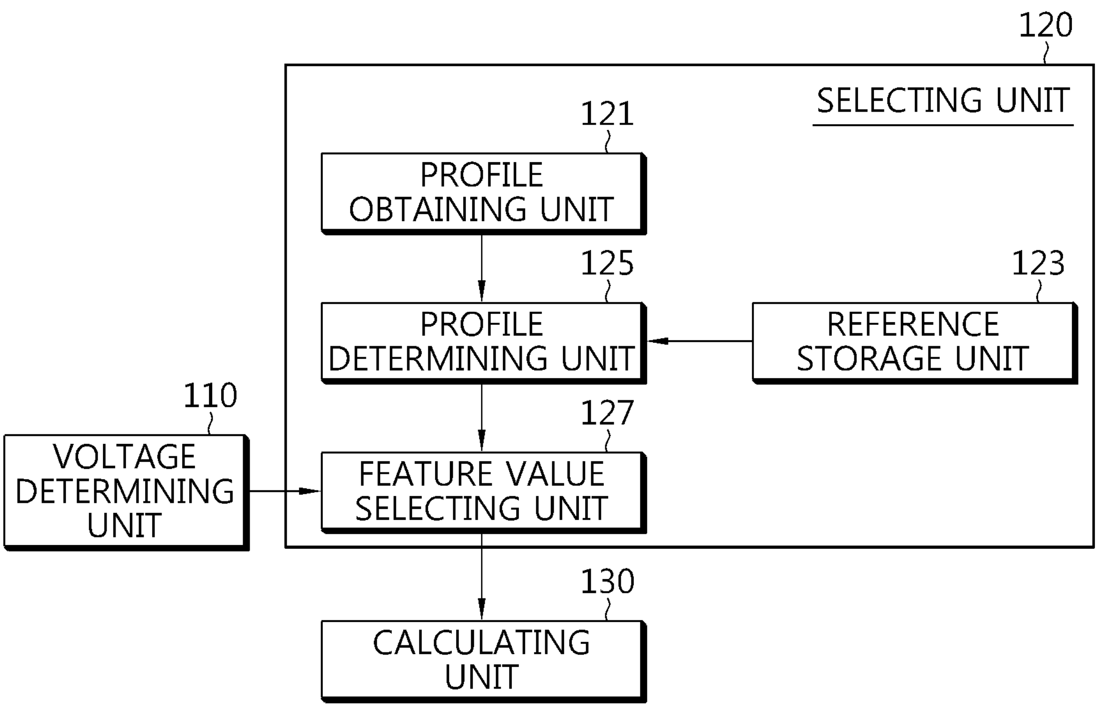
120
SELECTING UNIT
121
PROFILE OBTAINING UNIT
125
PROFILE DETERMINING UNIT
123
REFERENCE STORAGE UNIT
110
VOLTAGE DETERMINING UNIT
127
FEATURE VALUE SELECTING UNIT
130
CALCULATING UNIT

FIG. 3

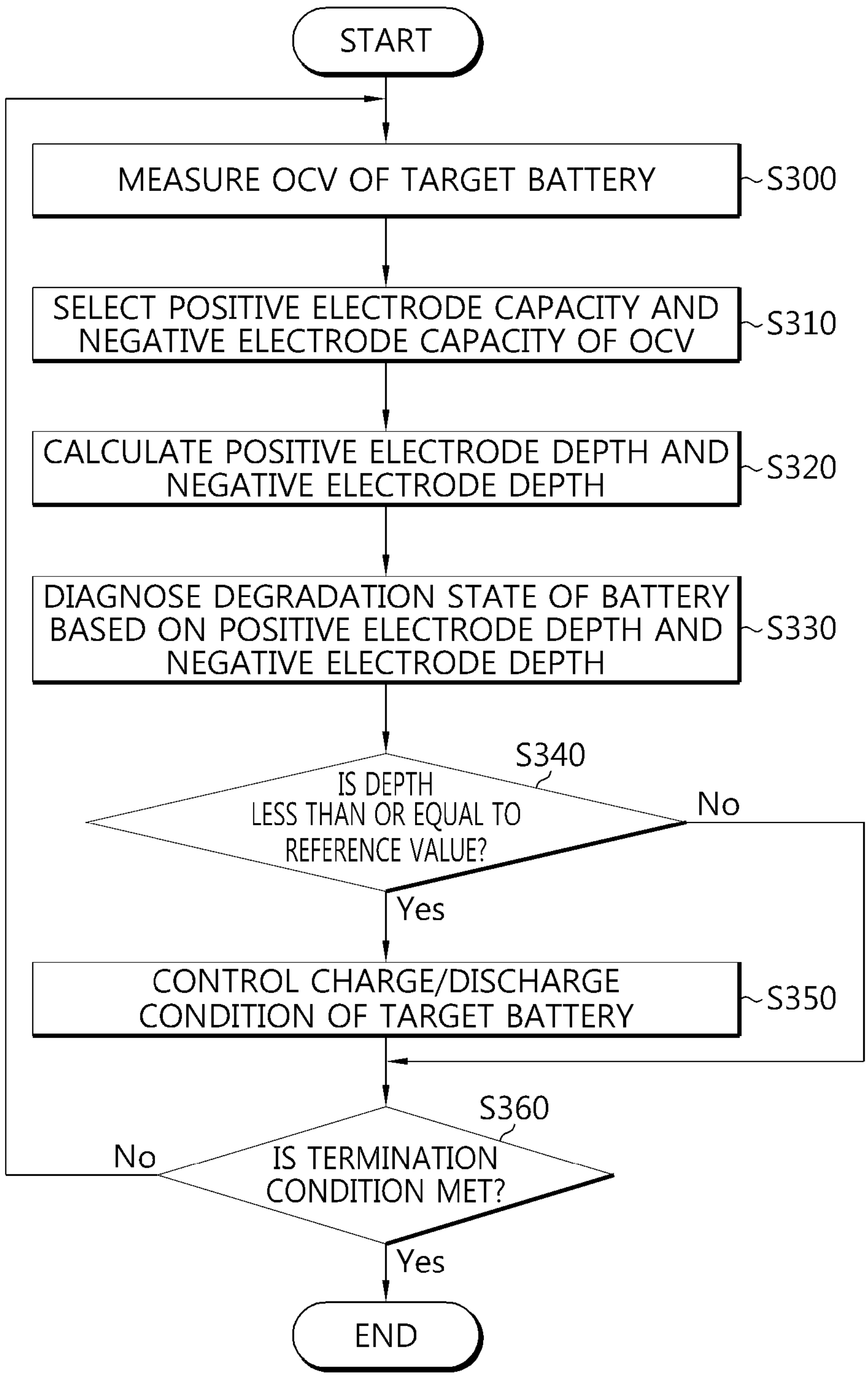
START
MEASURE OCV OF TARGET BATTERY
S300
SELECT POSITIVE ELECTRODE CAPACITY AND NEGATIVE ELECTRODE CAPACITY OF OCV
S310
CALCULATE POSITIVE ELECTRODE DEPTH AND NEGATIVE ELECTRODE DEPTH
S320
DIAGNOSE DEGRADATION STATE OF BATTERY BASED ON POSITIVE ELECTRODE DEPTH AND NEGATIVE ELECTRODE DEPTH
S330
S340
IS DEPTH LESS THAN OR EQUAL TO REFERENCE VALUE?
No
Yes
CONTROL CHARGE/DISCHARGE CONDITION OF TARGET BATTERY
S350
S360
No
IS TERMINATION CONDITION MET?
Yes
END

FIG. 4

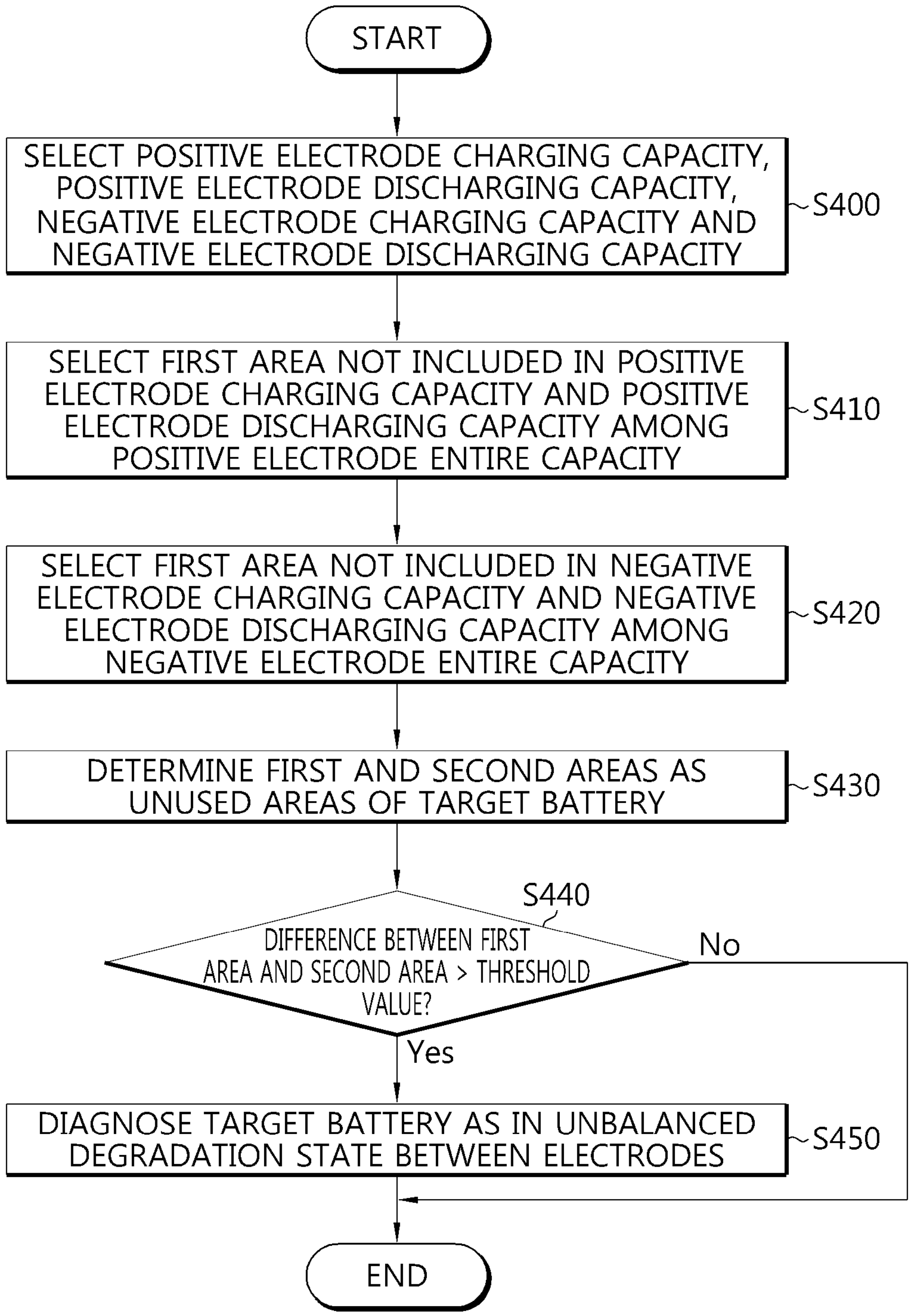
START
SELECT POSITIVE ELECTRODE CHARGING CAPACITY, POSITIVE ELECTRODE DISCHARGING CAPACITY, NEGATIVE ELECTRODE CHARGING CAPACITY AND NEGATIVE ELECTRODE DISCHARGING CAPACITY
S400
SELECT FIRST AREA NOT INCLUDED IN POSITIVE ELECTRODE CHARGING CAPACITY AND POSITIVE ELECTRODE DISCHARGING CAPACITY AMONG POSITIVE ELECTRODE ENTIRE CAPACITY
S410
SELECT FIRST AREA NOT INCLUDED IN NEGATIVE ELECTRODE CHARGING CAPACITY AND NEGATIVE ELECTRODE DISCHARGING CAPACITY AMONG NEGATIVE ELECTRODE ENTIRE CAPACITY
S420
DETERMINE FIRST AND SECOND AREAS AS UNUSED AREAS OF TARGET BATTERY
S430
S440
DIFFERENCE BETWEEN FIRST AREA AND SECOND AREA > THRESHOLD VALUE?
No
Yes
DIAGNOSE TARGET BATTERY AS IN UNBALANCED DEGRADATION STATE BETWEEN ELECTRODES
S450
END

FIG. 5

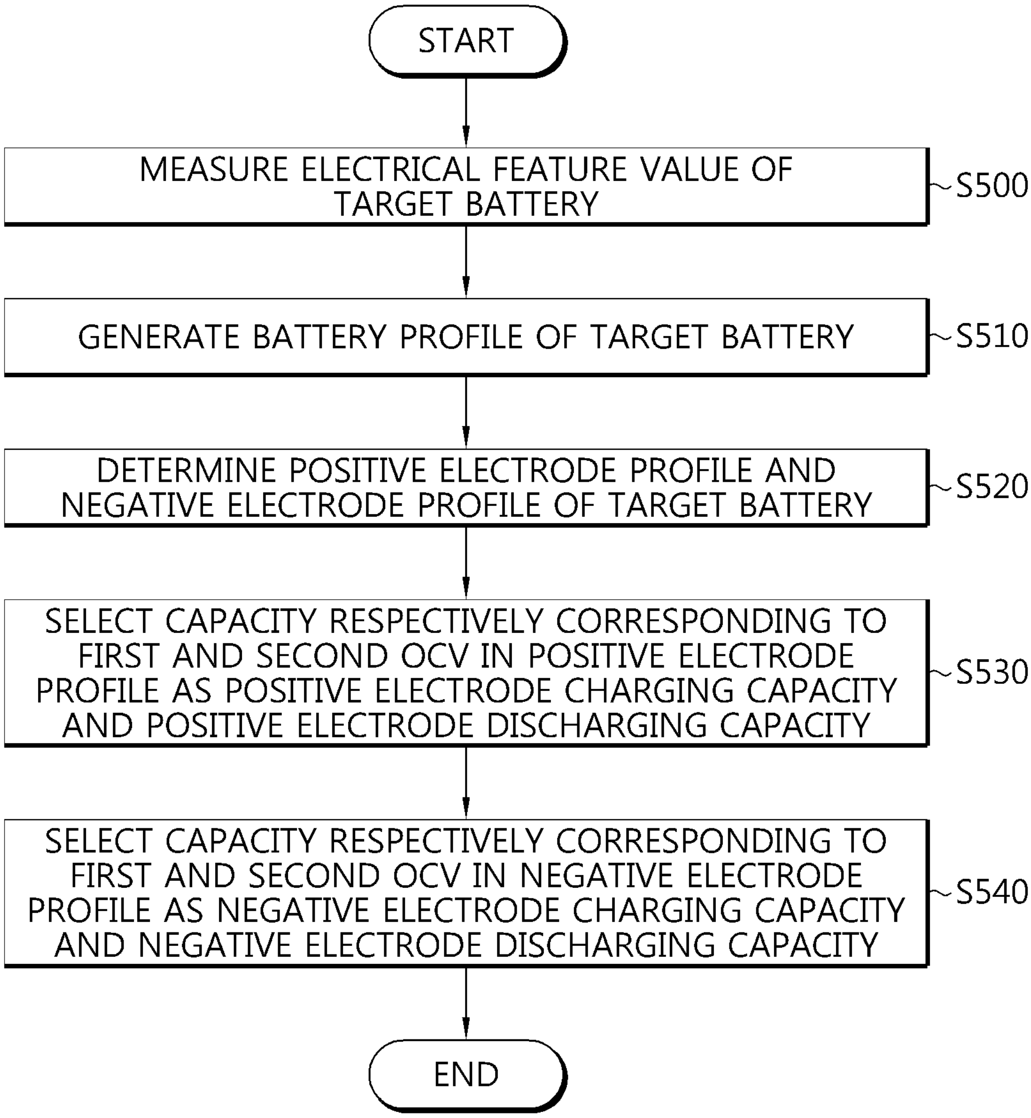
START
MEASURE ELECTRICAL FEATURE VALUE OF TARGET BATTERY
S500
GENERATE BATTERY PROFILE OF TARGET BATTERY
S510
DETERMINE POSITIVE ELECTRODE PROFILE AND NEGATIVE ELECTRODE PROFILE OF TARGET BATTERY
S520
SELECT CAPACITY RESPECTIVELY CORRESPONDING TO FIRST AND SECOND OCV IN POSITIVE ELECTRODE PROFILE AS POSITIVE ELECTRODE CHARGING CAPACITY AND POSITIVE ELECTRODE DISCHARGING CAPACITY
S530
SELECT CAPACITY RESPECTIVELY CORRESPONDING TO FIRST AND SECOND OCV IN NEGATIVE ELECTRODE PROFILE AS NEGATIVE ELECTRODE CHARGING CAPACITY AND NEGATIVE ELECTRODE DISCHARGING CAPACITY
S540
END

FIG. 6

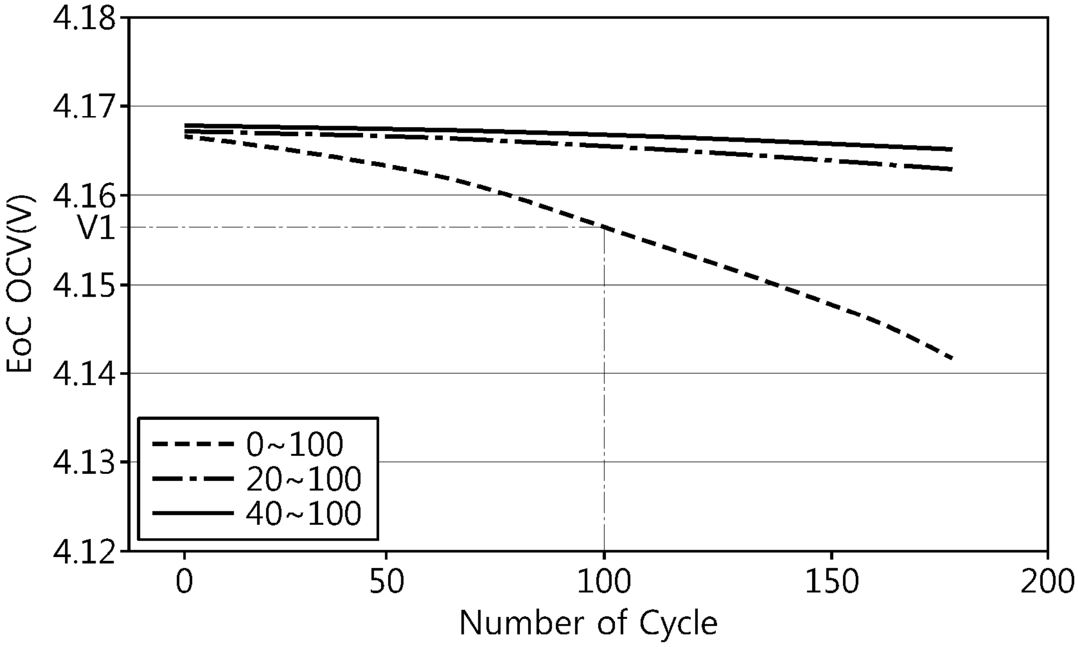
4.18
4.17
4.16
V1
4.15
4.14
4.13
4.12
EoC OCV(V)
0~100
20~100
40~100
0
50
100
150
200
Number of Cycle

FIG. 7

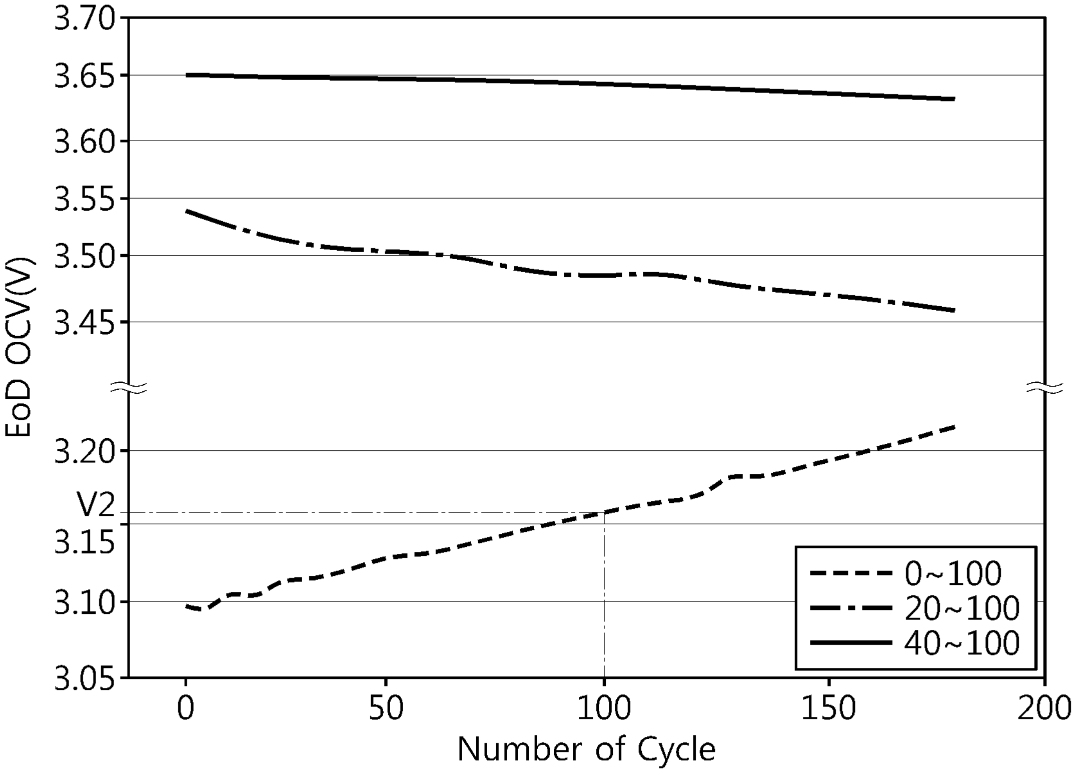
3.70
3.65
3.60
3.55
3.50
3.45
3.20
V2
3.15
3.10
3.05
EoD OCV(V)
0~100
20~100
40~100
0
50
100
150
200
Number of Cycle

FIG. 8

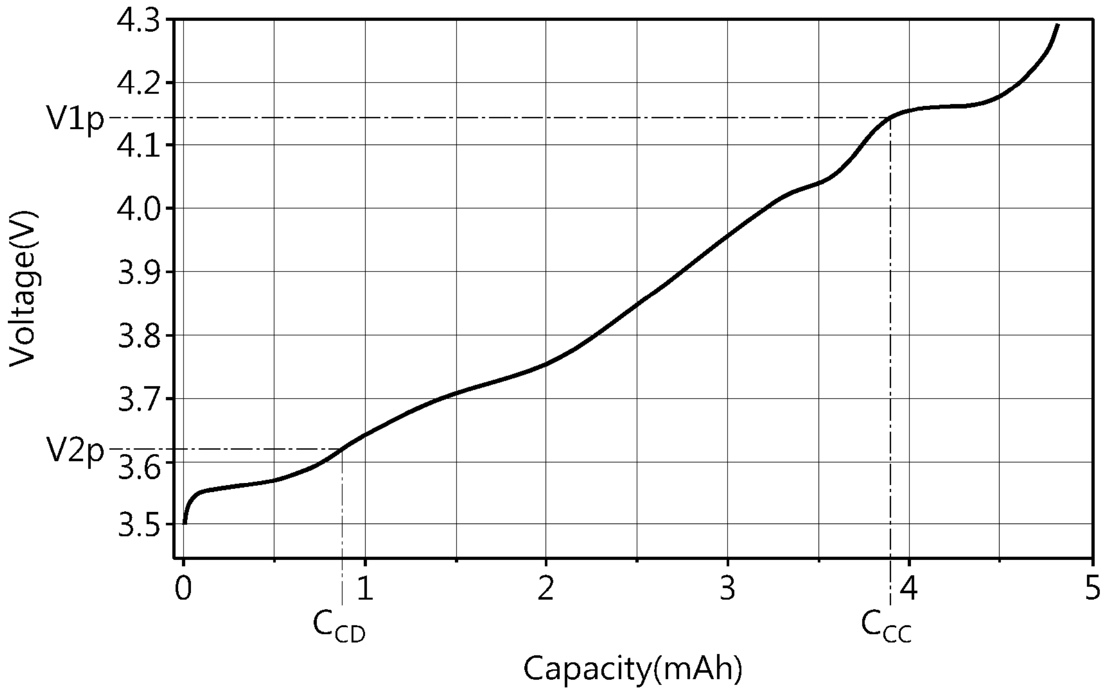
4.3
4.2
V1p
4.1
4.0
3.9
3.8
3.7
V2p
3.6
3.5
Voltage(V)
0
1
2
3
4
5
$C_{CD}$
$C_{CC}$
Capacity(mAh)

FIG. 9

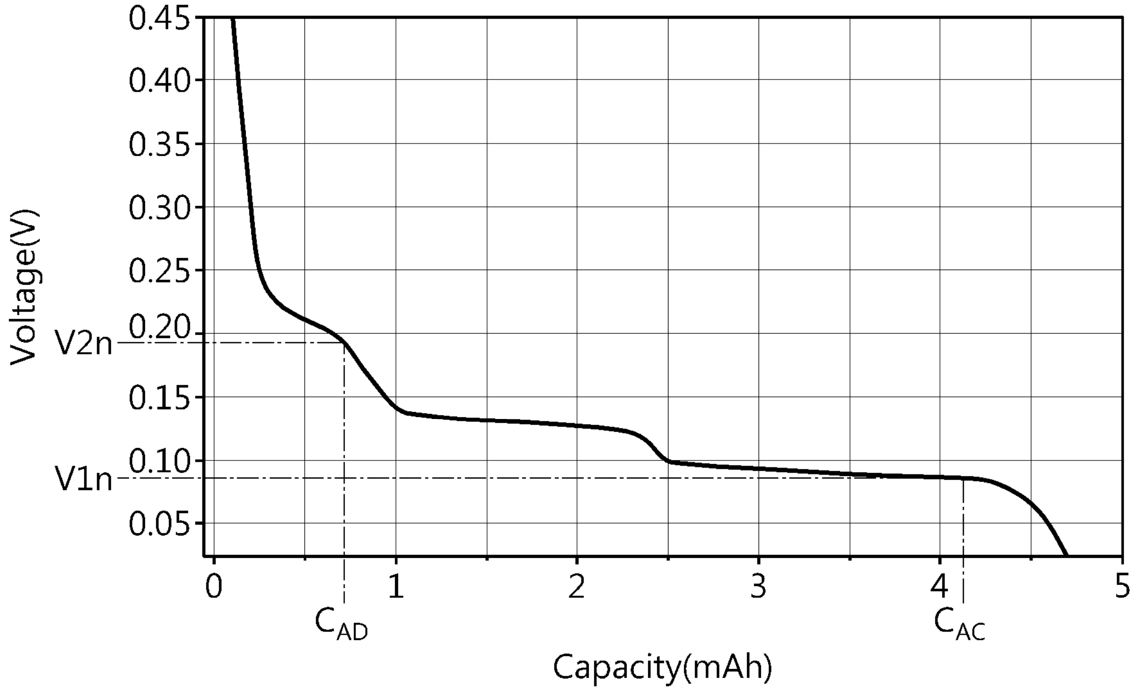
0.45
0.40
0.35
0.30
0.25
0.20
V2n
0.15
0.10
V1n
0.05
Voltage(V)
0
1
2
3
4
5
$C_{AD}$
$C_{AC}$
Capacity(mAh)

FIG. 10

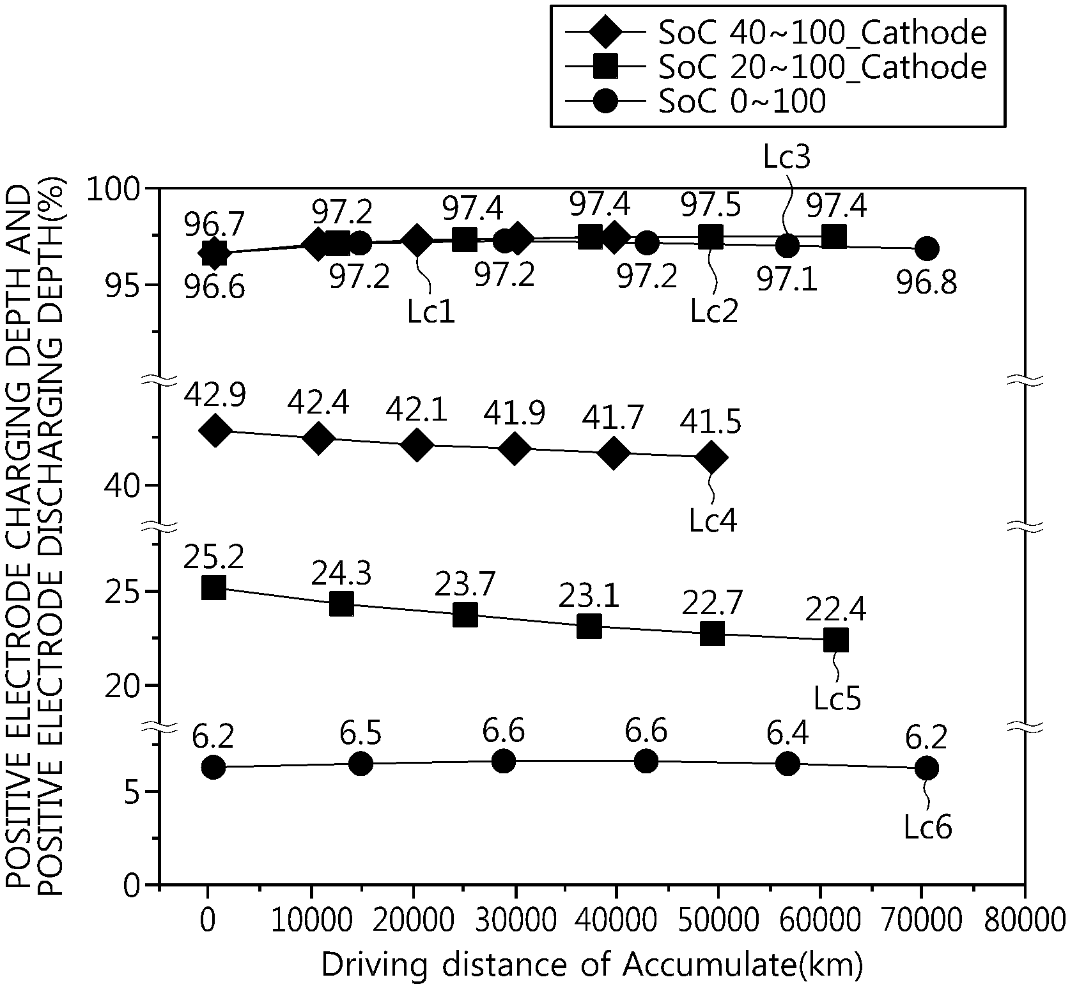
SoC 40~100_Cathode
SoC 20~100_Cathode
SoC 0~100
POSITIVE ELECTRODE CHARGING DEPTH AND POSITIVE ELECTRODE DISCHARGING DEPTH(%)
Driving distance of Accumulate(km)
0
10000
20000
30000
40000
50000
60000
70000
80000
100
95
40
25
20
5
0
96.7
96.6
97.2
97.2
97.4
97.2
97.4
97.2
97.5
97.1
97.4
96.8
Lc1
Lc2
Lc3
42.9
42.4
42.1
41.9
41.7
41.5
Lc4
25.2
24.3
23.7
23.1
22.7
22.4
Lc5
6.2
6.5
6.6
6.6
6.4
6.2
Lc6

FIG. 11

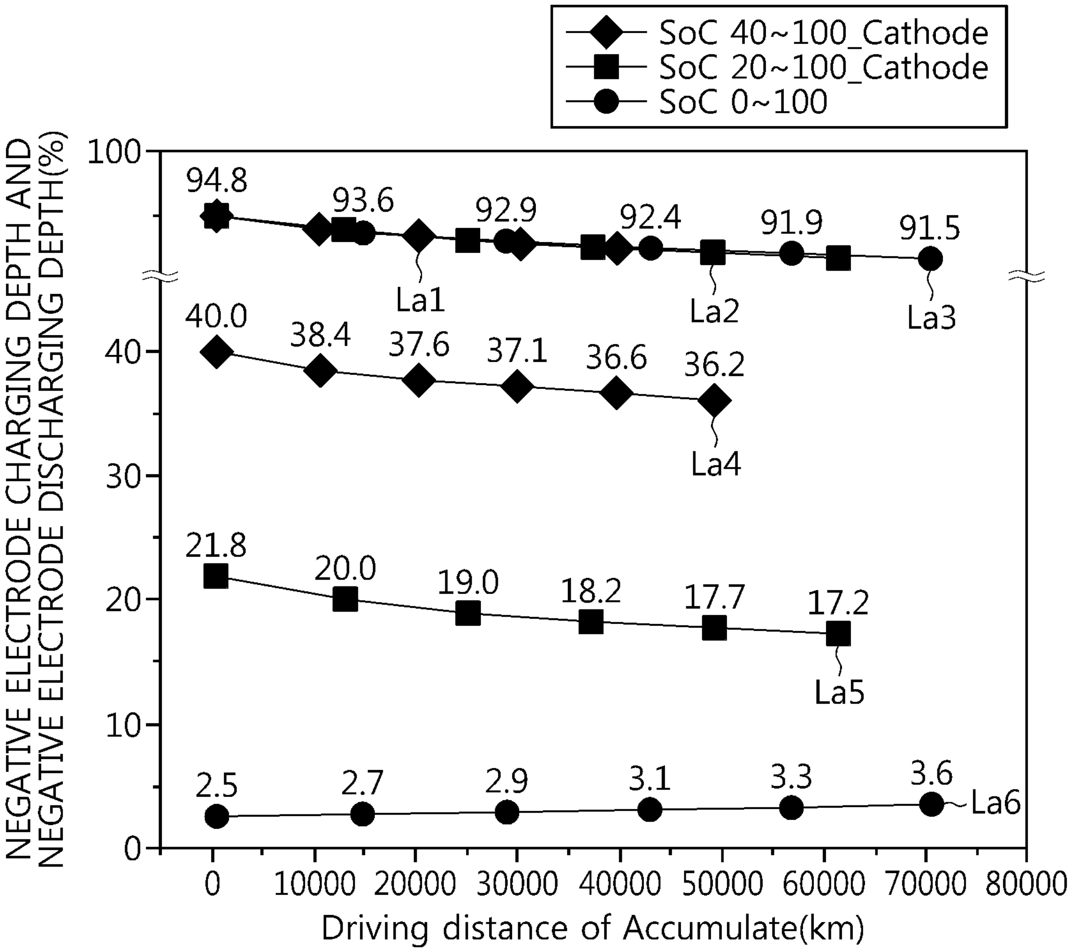
SoC 40~100_Cathode
SoC 20~100_Cathode
SoC 0~100
NEGATIVE ELECTRODE CHARGING DEPTH AND
NEGATIVE ELECTRODE DISCHARGING DEPTH(%)
100
40
30
20
10
0
94.8
93.6
92.9
92.4
91.9
91.5
La1
La2
La3
40.0
38.4
37.6
37.1
36.6
36.2
La4
21.8
20.0
19.0
18.2
17.7
17.2
La5
2.5
2.7
2.9
3.1
3.3
3.6
La6
0
10000
20000
30000
40000
50000
60000
70000
80000
Driving distance of Accumulate(km)

FIG. 12

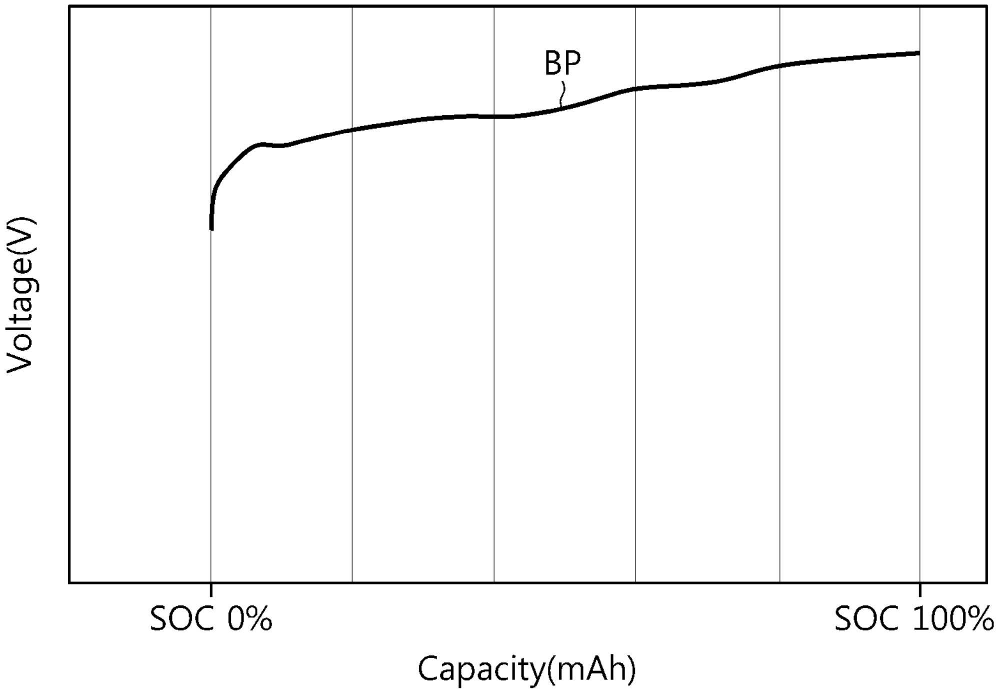
BP
Voltage(V)
SOC 0%
SOC 100%
Capacity(mAh)

FIG. 13

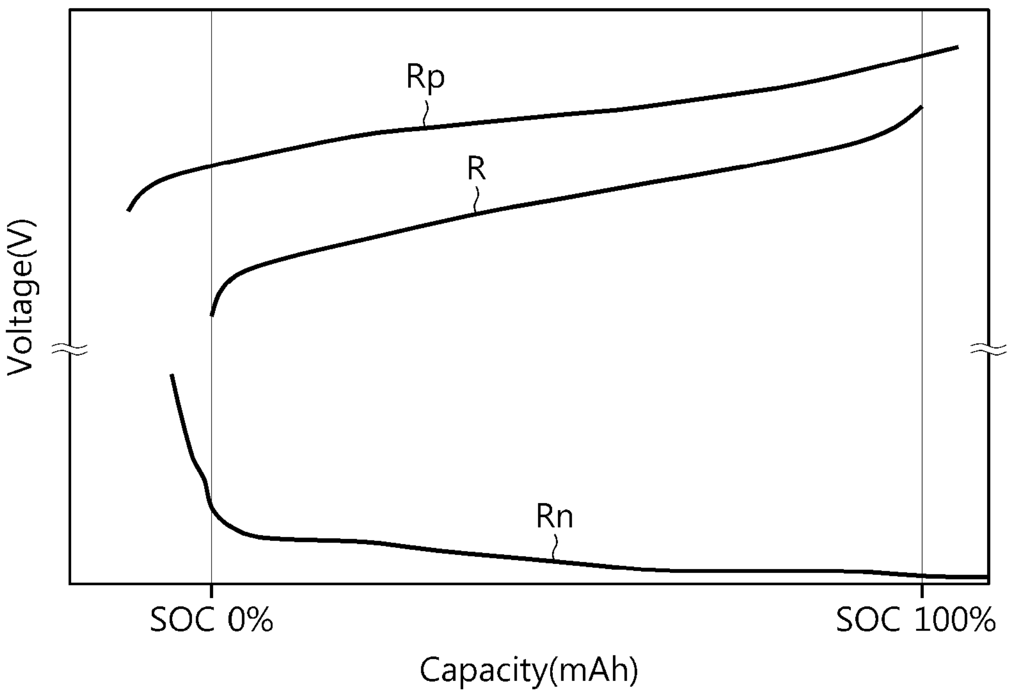
Rp
R
Rn
Voltage(V)
SOC 0%
SOC 100%
Capacity(mAh)

FIG. 14

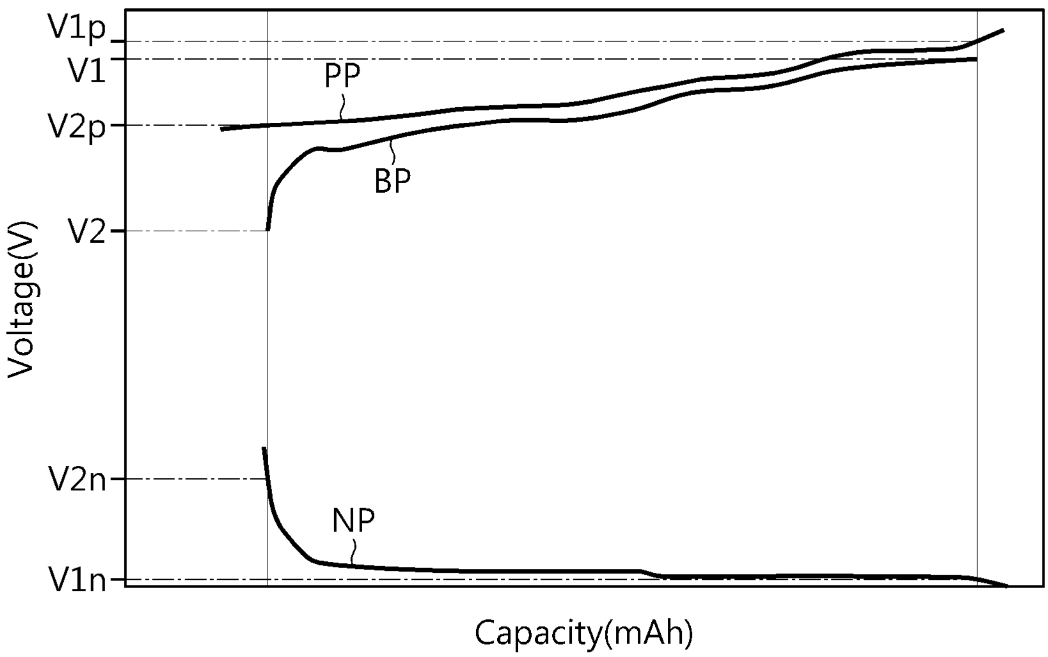

**INTERNATIONAL SEARCH REPORT**

International application No. **PCT/KR2025/002620**

**A. CLASSIFICATION OF SUBJECT MATTER**

**G01R 31/396**(2019.01)i; **G01R 31/382**(2019.01)i; **G01R 31/392**(2019.01)i; **B60L 58/16**(2019.01)i

According to International Patent Classification (IPC) or to both national classification and IPC

**B. FIELDS SEARCHED**

Minimum documentation searched (classification system followed by classification symbols)

G01R 31/396(2019.01); B60L 58/16(2019.01); G01R 31/3842(2019.01); G01R 31/392(2019.01); H01M 10/0525(2010.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 개방전압(open circuit voltage), 양극(positive electrode), 음극 (negative electrode), 심도(depth)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2019-0118536 A (LG CHEM, LTD.) 18 October 2019 (2019-10-18) See paragraphs [0072]-[0073], [0125], [0159] and [0164]; claim 15; and figures 1-11. | 1-15 |
| Y | KR 10-2022-0056150 A (LG ENERGY SOLUTION, LTD.) 04 May 2022 (2022-05-04) See paragraphs [0040], [0043]-[0045] and [0052]; and figures 1-2. | 1-15 |
| A | KR 10-2013-0122543 A (LG CHEM, LTD.) 07 November 2013 (2013-11-07) See paragraphs [0089]-[0123]; and figures 3-6. | 1-15 |
| A | KR 10-2022-0074258 A (LTOP, LTD.) 03 June 2022 (2022-06-03) See paragraphs [0114]-[0184]; and figures 9-15. | 1-15 |
| A | US 2020-0355749 A1 (SEMICONDUCTOR ENERGY LABORATORY CO., LTD.) 12 November 2020 (2020-11-12) See paragraphs [0012]-[0057]. | 1-15 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 June 2025** | **04 June 2025** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2025/002620**

| Patent document cited in search report | Publication date (day/month/year) | Patent family member(s) | Publication date (day/month/year) |
|---|---|---|---|
| KR 10-2019-0118536 A | 18 October 2019 | CN 111201445 A | 26 May 2020 |
| | | CN 111201445 B | 09 December 2022 |
| | | EP 3690461 A1 | 05 August 2020 |
| | | EP 3690461 A4 | 10 March 2021 |
| | | EP 3690461 B1 | 29 June 2022 |
| | | JP 2020-533759 A | 19 November 2020 |
| | | JP 7020720 B2 | 16 February 2022 |
| | | KR 10-2362886 B1 | 14 February 2022 |
| | | US 11163011 B2 | 02 November 2021 |
| | | US 11193985 B2 | 07 December 2021 |
| | | US 2021-0041506 A1 | 11 February 2021 |
| | | WO 2019-199064 A1 | 17 October 2019 |
| KR 10-2022-0056150 A | 04 May 2022 | CN 115443416 A | 06 December 2022 |
| | | EP 4148444 A1 | 15 March 2023 |
| | | EP 4148444 A4 | 11 December 2024 |
| | | JP 2023-519692 A | 12 May 2023 |
| | | JP 7400172 B2 | 19 December 2023 |
| | | KR 10-2688015 B1 | 24 July 2024 |
| | | US 12117501 B2 | 15 October 2024 |
| | | US 2023-0140094 A1 | 04 May 2023 |
| | | WO 2022-092827 A1 | 05 May 2022 |
| KR 10-2013-0122543 A | 07 November 2013 | CN 104395771 A | 04 March 2015 |
| | | EP 2837944 A1 | 18 February 2015 |
| | | EP 2837944 A4 | 13 January 2016 |
| | | EP 2837944 B1 | 01 May 2019 |
| | | JP 2015-523547 A | 13 August 2015 |
| | | JP 5946955 B2 | 06 July 2016 |
| | | KR 10-1487494 B1 | 29 January 2015 |
| | | PL 2837944 T3 | 31 October 2019 |
| | | US 2015-0066407 A1 | 05 March 2015 |
| | | US 9097773 B2 | 04 August 2015 |
| | | WO 2013-165089 A1 | 07 November 2013 |
| KR 10-2022-0074258 A | 03 June 2022 | KR 10-2562103 B1 | 02 August 2023 |
| US 2020-0355749 A1 | 12 November 2020 | CN 111542759 A | 14 August 2020 |
| | | CN 111542759 B | 09 February 2024 |
| | | DE 112018006835 T5 | 15 October 2020 |
| | | JP 2023-067894 A | 16 May 2023 |
| | | JP 2024-100785 A | 26 July 2024 |
| | | JP 7234140 B2 | 07 March 2023 |
| | | JP 7483078 B2 | 14 May 2024 |
| | | JP 7648831 B2 | 18 March 2025 |
| | | KR 10-2020-0107987 A | 16 September 2020 |
| | | KR 10-2810504 B1 | 22 May 2025 |
| | | TW I814765 B | 11 September 2023 |
| | | TW I856802 B | 21 September 2024 |
| | | TW 201930910 A | 01 August 2019 |
| | | TW 202349010 A | 16 December 2023 |
| | | US 2024-0118344 A1 | 11 April 2024 |
| | | WO 2019-138286 A1 | 18 July 2019 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020240040392